# EUROPEAN PATENT APPLICATION

(11) **EP 2 098 367 A1**
(43) Date of publication of application: **09.09.2009**
(21) Application number: 08152310.2
(22) Date of filing: 05.03.2008
(51) Int. Cl.: B41C 1/10, B41M 5/36, C08F 2/46, C09B 69/06, G03F 7/029, B41M 5/46

(54) **Sensitizer/Initiator Combination for Negative-Working Thermal-Sensitive Compositions Usable for Lithographic Plates**

(71) Applicant: Eastman Kodak Company, Rochester NY 14650-2201 (US)
(72) Inventor: Simpson, Christopher, 37520 Osterode (DE); Baumann, Harald, 37520 Osterode/Harz (DE); Strehmel, Bernd, 13585 Berlin (DE)
(74) Representative: Vossius & Partner

(57) **Abstract**

The radiation-sensitive composition and the negative working imageable element include a cationic IR absorber with tetraarylborate counteranion and an onium initiator with tetraarylborate counteranion. The use of these components provides high imaging sensitivity, good shelflife and high print run length.

## Description

This invention relates to negative-working, IR-sensitive compositions and imageable elements such as negative-working lithographic printing plate precursors that have increased photospeed, longer length of run in lithographic printing, and good shelf life. The invention also relates to methods for producing these imageable elements as well as imaged elements obtained therefrom.

Negative-working radiation-sensitive compositions are routinely used in the preparation of imageable materials including lithographic printing plate precursors. Such compositions generally include a radiation-sensitive component, a radically polymerizable component, an initiator system, and optionally a binder, each of which has been the focus of research to provide various improvements in physical properties, imaging performance, and image characteristics.

Recent developments in the field of printing plate precursors concern the use of radiation-sensitive compositions that can be imaged by means of lasers or laser diodes. Laser exposure does not require conventional silver halide graphic arts films as intermediate information carriers (or "masks") since the lasers can be controlled directly by computers. High-performance lasers or laser-diodes that are used in commercially-available image-setters generally emit radiation having a wavelength of at least 700 nm, and thus the radiation-sensitive compositions are required to be sensitive in the near-infrared or infrared region of the electromagnetic spectrum.

For negative-working printing plates, exposed regions in the radiation-sensitive compositions are hardened and unexposed regions are washed off during development.

Various negative-working radiation-sensitive compositions and imageable elements containing reactive polymer binders are known in the art. Some of these compositions and elements are described for example in U.S. Patent 6,569,603 (Furukawa), 6,309,792 (Hauck et al.), 6,582,882 (Pappas et al.), 6,893,797 (Munnelly et al.), 6,787,281 (Tao et al.), and 6,899,994 (Huang et al.), U.S. Patent Application Publication 2003/0118939 (West et al.), and EP 1 079 276 A1 (Lifka et al.), EP 1 182 033 A1 (Fujimaki et al.), and EP 1449 650 A1 (Goto).

Some negative-working compositions and imageable elements include onium salts, including iodonium borate salts as initiators or ionic sensitizers with a borate anion.

JP 2002-062642 discloses negative type image recording material which is imaged by IRradiation. The material contains (A) a cationic dye having absorption in the IR region and using a tetraaryl borat as a counter anion, (B) a thermal radical generating agent, and (C) a radical polymerizable compound.

EP 1 757 982 discloses a negative working photosensitive composition comprising (A) an infrared absorber, (B) an organic boron compound, (C) a compound having a polymerizable unsaturated group, and (D) a binder resin having a sulfonamide or active imino group.

EP 1 467 250 discloses IR-sensitive compositions containing (A) an IR-absorber, (B) a borate compound comprising the anion BR₄⁻, wherein at least one R is alkyl, (C) binder polymer, (D) polymerizable compound , and (E) a mono or polycarboxylic acid having a molecular weight of not more than 3.000 (e.g. anilino diacetic acid).

US 7,279,255 B2 discloses a radiation-sensitive composition comprising (A) a radically polymerizable component, (B) a borate initiator capable of generating radicals sufficient to initiate polymerization of said radically polymerizable component upon exposure to imaging radiation, (C) a radiation absorbing compound, (D) a polymeric binder comprising a polymer backbone to which is directly or indirectly linked a pendant group comprising a reactive vinyl group, and (E) a primary additive that is a poly(alkylene glycol) or an ether or ester thereof.

EP 1 168 081 A1 discloses a photopolymerizable composition comprising (A) a polymerizable compound having an addition-polymerizable unsaturated bond; (B) an organic dye; and (C) at least one kind of an organoboron compound B(R₄)⁻X⁺ in a proportion of at least one mole per mole of the organic dye, wherein each R is independently selected from a long list of organic groups or two or more thereof are linked to form a B-heterocycle, and X is selected from a long list of metal cations and organic cations, especially ammonium cations.

US 7,189,494 B2 discloses an imageable element comprising a lithographic substrate, and disposed on the substrate, an imageable layer including (A) a radically polymerizable component; (B) an initiator system capable of generating radicals sufficient to initiate a polymerization reaction upon exposure to imaging radiation; and (C) a polymeric binder having a hydrophobic backbone and including both (i) constitutional units having a pendant group attached directly to the hydrophobic backbone, and (ii) constitutional units having a pendant group including a hydrophilic poly(alkylene oxide) segment; wherein the imageable element further comprises a tetraarylborate salt.

WO2007/139687 A1 discloses a radiation-sensitive composition comprising: (A) a free radically polymerizable component, (B) an iodonium borate initiator capable of generating radicals sufficient to initiate polymerisation of said radically polymerizable component upon exposure to imaging radiation, (C) a radiation absorbing compound, and (D) a polymeric binder.

JP 2000-089455 discloses the use of cyanine dyes as sensitizers for photopolymerizable compositions, wherein the dye has a cyanine cation and a borat anion.

EP 915 136 A1 discloses photocurable paint compositions for road markings comprising a polymerizable compound, a filler, a cationic dye, a quaternary organic borat-type sensitizer and a UV radical polymerisation initiator.

The various radiation sensitive compositions of the art can readily be used to prepare negative-working imageable elements, including those containing onium borates as polymerization initiators. Nevertheless, there is a desire to further improve the digital imaging speed and the print run length of printing plates without any decrease in shelflife.

The present invention provides a radiation-sensitive composition comprising:
(a) a sensitizer dye capable of absorbing radiation of the range of 700 to 1200 nm
(b) an initiator generating radicals in interacting with the exposed sensitizer
(c) a free radical polymerizable component, and
(d) optionally a polymeric binder,
wherein the sensitizer dye is a cationic dye having a tetraarylborate counter-anion and the initiator is an onium compound from diaryliodonium tetraarylborates, triarylsulfonium tetraarylborates, diazonium tetraarylborates, phosphonium tetraarylborates, and N-heterocyclic onium tetraarylborates wherein the N is substituted with -OR, and R is an optionally substituted hydrocarbyl.

This invention also provides an imageable element comprising a substrate having thereon an imageable layer comprising:
(a) a sensitizer dye capable of absorbing radiation of the range of 700 to 1200 nm
(b) an initiator generating radicals in interacting with the exposed sensitizer
(c) a free radical polymerizable component
(d) optionally a polymeric binder,
wherein the sensitizer dye is a cationic dye having a tetraarylborate counter-anion and the initiator is an onium compound selected from diaryliodonium tetraarylborates, triarylsulfonium tetraarylborates, diazonium tetraarylborates, phosphonium tetraarylborates, and N-heterocyclic onium tetraarylborates wherein the N is substituted with -OR, and R is an optionally substituted hydrocarbyl.

Further, the invention provides a method of making an imaged element, wherein the method comprises:
A) imagewise exposing the negative-working imageable element as described above to IR radiation having a wavelength of 700 to 1200 nm;
B) developing the imagewise exposed element to remove only the non-exposed regions of the imageable layer.

The imaged elements provided by this method are particularly useful as lithographic printing plates.

Still again, this invention provides a method of making an imageable element comprising applying a radiation-sensitive composition as defined above to a substrate.

### Definitions

Unless the context indicates otherwise, when used herein, the terms "radiation-sensitive composition", "imageable element", and "printing plate precursor" are meant to be references to embodiments of the present invention.

In addition, unless the context indicates otherwise, the various components described herein such as "free radical polymerizable compound", "sensitizer", "initiator", "polymeric binder", "onium compound", and similar terms also refer to mixtures of such components. Thus, the use of the articles "a", "an", and "the" are not necessarily meant to refer to only a single component.

Unless indicated otherwise "alkyl" refers to straight chain and branched saturated hydrocarbyl groups.

Moreover, unless otherwise indicated, percentages refer to percents by dry weight.

Within the present application percentages based on the dry layer weight are considered to be the same as percentages based on the solids of the coating composition.

### Radiation-sensitive Compositions

### Free-radical polymerizable component

The free-radical polymerizable component used in the radiation-sensitive composition consists of one or more compounds that have one or more ethylenically unsaturated polymerizable or crosslinkable groups that can be polymerized or crosslinked using free radical initiation. For example, the free-radical polymerizable component can be ethylenically unsaturated monomers, oligomers, and polymers including crosslinkable polymers, or a combination of such compounds. Such free-radical polymerizable components are not intended to include the cationically or acid-catalytically polymerizable or crosslinkable compounds described, for example in U.S. Patent 6,306,555 (Schulz et al.) such as the cyclic ethers (including non-acrylate-containing epoxides), vinyl ethers, hydroxy compounds, lactones, cyclic thioethers, and vinyl thioethers.

Monomers/oligomers with C-C triple bonds can also be used, but they are not preferred.

Suitable compounds are well known to the person skilled in the art and can be used in the present invention without any particular limitations. Esters of acrylic and methacrylic acids, itaconic acid, crotonic acid, isocrotonic acid, maleic acid and fumaric acid with one or more unsaturated groups in the form of monomers, oligomers or prepolymers are preferred. They may be present in solid or liquid form, with solid and highly viscous forms being preferred. Compounds suitable as monomers include for instance tri(methylol propane) triacrylate and trimethacrylate, pentaerythritol triacrylate and trimethacrylate, dipentaerythritolmonohydroxy pentaacrylate and pentamethacrylate, dipentaerythritol hexaacrylate and hexamethacrylate, pentaerythritol tetraacrylate and tetramethacrylate, di(trimethylol propane)tetraacrylate and tetramethacrylate, diethyleneglycol diacrylate and dimethacrylate, triethyleneglycol diacrylate and dimethacrylate or tetraethyleneglycol diacrylate and dimethacrylate. Suitable oligomers and/or prepolymers are for example urethane acrylates and methacrylates, epoxide acrylates and methacrylates, polyester acrylates and methacrylates, polyether acrylates and methacrylates or unsaturated polyester resins; within the scope of this invention oligomers/prepolymers have a weight average molecular weight (determined by gelpermeation chromatography GPC using polystyrene standards) of up to 10000 g/mol.

Free-radical polymerizable compounds that can be used in the present invention also include compounds disclosed in DE 103 56 847 A1 that have a molecular weight of 10,000 or less and are reaction products obtained by reacting a diisocyanate with (i) an ethylenically unsaturated compound with a hydroxy group, and at the same time (ii) a saturated organic compound with an NH group and an OH group, wherein the reactants are used in amounts according to the following condition:
Number of moles of isocyanate groups ≤ number of moles of OH plus NH groups.

Examples of diisocyanates are represented by the following formula:

O = C = N -(CR¹₂)ₐ-D-(CR¹₂)_{b}- N = C = O (I)

wherein a and b independently represent 0 or an integer from 1 to 3, each R¹ is independently selected from H and C₁-C₃ alkyl and D is a saturated or unsaturated spacer which can optionally comprise further substituents in addition to the two isocyanate groups. D can be a chain-shaped or a ring-shaped unit. As used in the present invention, the term "diisocyanate" refers to an organic compound comprising two isocyanate groups but no OH groups and secondary or primary amino groups.
R¹ is preferably H or CH₃.
a and b are preferably independently 0 or 1.

D can for example be an alkylene group (CH₂)_{w}, wherein w is an integer from 1 to 12, preferably 1 to 6, and one or more hydrogen atoms are optionally replaced with substituents such as e.g. alkyl groups (preferably C₁-C₆), a cycloalkylene group, an arylene group or a saturated or unsaturated heterocyclic group.

Suitable diisocyanates are for example the following:
Trimethylhexamethylene diisocyanate, 1,6-bis-[isocyanate]-hexane, 5-isocyanate-3-(isocyanatomethyl)-1,1,3-trimethylcyclohexane, 1,3-bis-[5-isocyanate-1,1,3-trimethyl-phenyl]-2,4-dioxo-1,3-diazetidine, 3,6-bis-[9-isocyanatononyl]-4,5-di-(1-heptenyl)-cyclohexene, bis-[4-isocyanate-cyclohexyl]-methane, trans-1,4-bis-[isocyanate]-cyclohexane, 1,3-bis-[isocyanatomethyl]-benzene, 1,3-bis-[1-isocyanate-1-methyl-ethyl]-benzene, 1,4-bis-[2-isocyanatoethyl]-cyclohexane, 1,3-bis-[isocyanatomethyl]cyclohexane, 1,4-bis-[1-isocyanate-1-methyl-ethyl]benzene, bis-[isocyanate]-isododecyl-benzene, 1,4-bis-[isocyanate]-benzene, 2,4-bis-[isocyanate]-toluene, 2,6-bis-[isocyanate]-toluene, N,N'-bis-[3-isocyanate-4-methyl-phenyl] urea, 1,3-bis-[3-isocyanate-4-methyl-phenyl]-2,4-dioxo-1,3-diazetidine, bis-[2-isocyanate-phenyl]-methane, (2-isocyanate-phenyl)-(4-isocyanate-phenyl)-methane, bis-[4-isocyanate-phenyl]-methane, 1,5-bis-[isocyanate]-naphthalene and 4,4'-bis-[isocyanate]-3,3'-dimethyl-biphenyl.

The ethylenically unsaturated compound (i), which comprises a hydroxy group, comprises at least one non-aromatic C-C double bond, which is preferably terminal. The hydroxy group is preferably not bonded to a doubly bonded carbon atom; the hydroxy group is not part of a carboxy group. In addition to the one OH group, the ethylenically unsaturated compound (i) does not comprise any further functional groups, such as e.g. NH, which can react with the isocyanate.

Examples of the ethylenically unsaturated compound (i) include Hydroxy(C₁-C₁₂)alkyl(meth)acrylates (e.g. 2-hydroxyethyl(meth)acrylate, 2- or 3-hydroxypropyl(meth)acrylate, 2-, 3- or 4-hydroxybutyl(meth)acrylate), hydroxy(C₁-C₁₂)alkyl(meth)acrylamides (e.g. 2-hydroxyethyl(meth)acrylamide, 2- or 3-hydroxypropyl(meth)acrylamide, 2-, 3- or 4-hydroxybutyl(meth)acrylamide), mono(meth)acrylates of oligomeric or polymeric ethylene glycols or propylene glycols (e.g. polyethylene glycol mono(meth)acrylate, triethylene glycol mono(meth)acrylate), allyl alcohol, pentaerythritol tri(meth)acrylate, 4-hydroxy(C₁-C₁₂)alkyl-styrene (e.g. 4-hydroxymethylstyrene), 4-hydroxystyrene, hydroxycyclohexyl(meth)acrylate.

The term "(meth)acrylate" etc. as used in the present invention indicates that both methacrylate and acrylate etc. are meant.

The saturated organic compound (ii) is a compound with one OH and one NH group.

The saturated organic compound (ii) can for example be represented by the following formula (II) or (III) 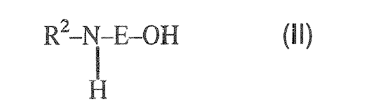 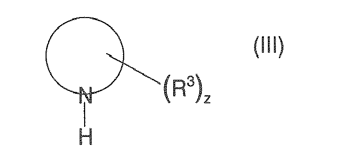 wherein R² is a straight-chain (preferably C₁-C₁₂, especially preferred C₁-C₄), branched (preferably C₃-C₁₂, especially preferred C₃-C₆) or cyclic (preferably C₃-C₈, especially preferred C₅-C₆) alkyl group,
E is a straight-chain (preferably C₁-C₆, especially preferred C₁-C₂), branched (preferably C₃-C₁₂, especially preferred C₃-C₆) or cyclic (preferably C₃-C₈, especially preferred C₅-C₆) alkylene group, 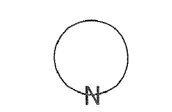 represents a saturated heterocyclic ring with 5 to 7 ring atoms, which in addition to the nitrogen atom shown above optionally comprises another heteroatom selected from S, O and NR⁴, wherein R⁴ is an alkyl group optionally substituted with an OH group,
R³ is OH or a straight-chain, branched or cyclic alkyl group substituted with an OH group, and z = 0 if the heterocyclic ring comprises NR⁴ and R⁴ is an alkyl group substituted with OH and z = 1 if the saturated heterocyclic ring does not comprise NR⁴ or if the saturated heterocyclic ring comprises NR⁴ and R⁴ is an unsubstituted alkyl group.

Of the compounds of formula (II), those are preferred wherein E represents -CH₂CH₂- and R² is a straight-chain C₁-C₁₂ (preferably C₁-C₄) alkyl group.

Of the compounds of formula (III), those are preferred wherein either no additional heteroatom is present in the ring and R³ is an alkyl group substituted with OH (i.e. hydroxyalkyl-substituted piperidines), or a group NR⁴ is present in the ring and R⁴ is an alkyl group substituted with OH (i.e. N-hydroxyalkyl-substituted piperazines).

In particular, the following compounds should be mentioned as compound (ii):
2- or 3-(2-hydroxyethyl)piperidine, 2- or 3-hydroxymethylpiperidine, N-(2-hydroxyethyl)piperazine and N-(2-hydroxymethyl)piperazine.

The number of moles of isocyanate groups must not exceed the number of moles of OH groups and NH groups combined since the product should not comprise any more free isocyanate groups.

The reaction of the diisocyanate and the ethylenically unsaturated compound (i) and the saturated compound (ii) usually takes place in an aprotic solvent such as a ketone (e.g. acetone, methyl ethyl ketone, diethyl ketone, cyclopentanone and cyclohexanone), an ether (e.g. diethyl ether, diisopropyl ether, tetrahydrofuran, dioxane and 1,2-dioxolane) and an ester (e.g. ethyl acetate, methyl acetate, butyl acetate, ethylene glycol diacetate, methyl lactate and ethyl lactate) or in a technical solvent such as ethylene glycol monomethyl ether acetate, propylene glycol monomethyl ether acetate etc.

It is preferred to use a catalyst for condensation reactions. All known catalysts suitable for condensation reactions can be used. Examples include tertiary amines, such as triethylamine, pyridine etc. and tin compounds, such as dibutyltin dilaurate.

The reaction preferably takes place at 10 to 120°C, especially preferred at 30 to 70°C.

Under optimized synthesis conditions a uniform product can be obtained. However, as a rule it has to be assumed that a mixed product is formed. The molecular weight of the product should be 3,000 or less. In the case of a mixed product, the molecular weight is the weight-average molecular weight. Both a uniform reaction product and a mixed product can be used as a free-radical polymerizable compound in the present invention.

Additional suitable C-C unsaturated free-radical polymerizable compounds are described e.g. in EP-A-1 176 007.

Another group of suitable unsaturated oligomers is represented by Formula (IV): 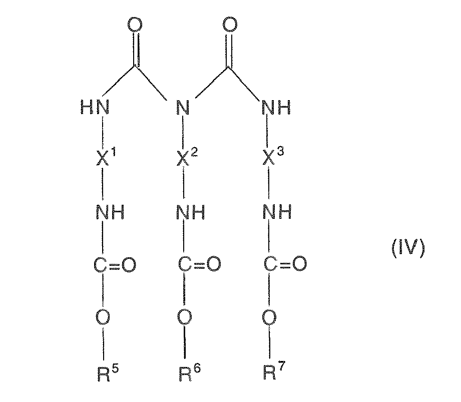 wherein X¹, X² and X³ are independently selected from straight-chain or cyclic C₄ - C₁₂ alkylene and C₆ - C₁₀ arylene, a heterocyclic group, a heteroaromatic group and combinations of two or more of the above,
R⁵, R⁶ and R⁷ are independently selected from 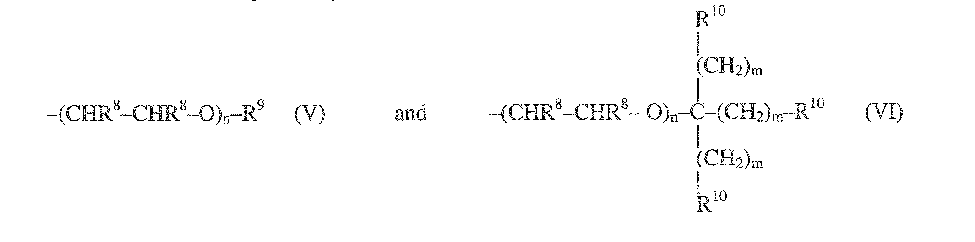 wherein
each R⁸ is independently selected from a hydrogen atom and CH₃, each n is independently 0 or an integer from 1 to 20, each m is independently 0 or 1;
if n in formula (V) is 0, R⁹ is independently selected from

- CH = CH₂, - CH₂ - CH = CH₂

and 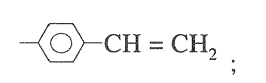 if n in formula (V) is an integer from 1 to 20, R⁹ is independently selected from 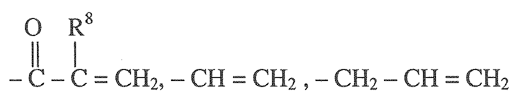 and 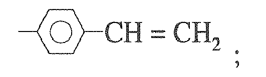 and each R¹⁰ is independently selected from a hydrogen atom, 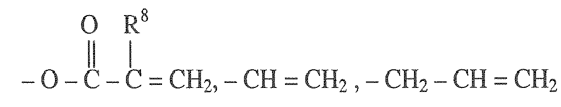 and 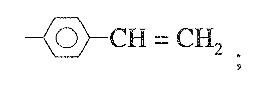 with the proviso that (1) n = 0 in at least one of the groups R⁵, R⁶ and R⁷, and (2) n > 2 in at least one of the groups R⁵, R⁶ and R⁷, and (3) at least one group R¹⁰ is different from H in formula (VI).

In formula (V), n is preferably > 2; especially preferred, n ≥ 6.

In formula (VI), n is preferably 0 and m is preferably 0 or 1.

R¹⁰ is preferably 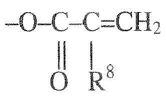 or H, with the proviso that at least one R¹⁰ is different from H.

It is preferred that the at least one group of R⁵, R⁶ and R⁷ wherein n > 2 is represented by formula (V).

It is preferred that in the spacer -(CHR⁸-CHR⁸-O)- either both groups R⁸ represent hydrogen, or that one represent hydrogen and the other CH₃. The spacer -(CHR⁸-CHR⁸-O)ₙ- can for example be polyethylene glycol units, polypropylene glycol units or a block copolymer unit with one or more polypropylene glycol blocks and one or more polyethylene glycol blocks.

According to one embodiment, two of the groups R⁵, R⁶ and R⁷ are glycerin-1,3-di(meth)acrylate groups and the third a polyethylene glycol(meth)acrylate group or a polypropylene glycol(meth)acrylate group (each with n > 2, preferably n ≥ 6).

The oligomer A of formula (IV) can be prepared as follows:
In a first step, the basic biuret structure is prepared by reacting at least one diisocyanate of the formula

   O=C=N-X-N=C=O
(wherein X is defined as are X¹, X² and X³) and an appropriately selected amount of water, usually 3 moles diisocyanate(s) and 1 mole water (see also e.g. DE-B-1,101,394 and Houben-Weyl, Methoden der organischen Chemie [methods in organic chemistry], 4th edition (1963), Vol. 14/2, pages 69 et seqq.). The reaction is preferably carried out without a solvent.

In a second step, the terminal isocyanate groups are reacted with at least two different unsaturated compounds of the following formula comprising one or more hydroxy groups

HO-(CHR⁸-CHR⁸-O)ₙ-R⁹ (Va)

and/or 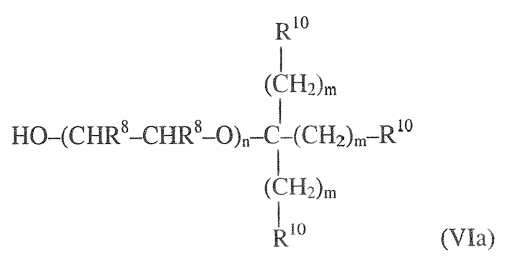 (wherein R⁸, R⁹, R¹⁰, n and m are as defined above) so that a compound of formula (IV) is obtained wherein n = 0 in at least one of groups R⁵, R⁶ and R⁷ and n > 2 in at one of them.

Further suitable free-radical polymerizable oligomers are oligomers A which have an average molecular weight of 3,500 to 9,000 determined by gel-permeation chromatography (GPC) with polystyrene standards, and are prepared by reacting a triisocyanate, preferably a triisocyanate of the formula (VII), (VIII) or (IX-1) to (IX-7) shown below, with (i) at least one (meth)acrylic monomer with two free OH groups and (ii) at least one (meth)acrylic compound with one free OH group and a poly(alkyleneoxide) chain, and optionally (iii) at least one (meth)acrylic monomer with one free OH group but no poly(alkyleneoxide) chain; the amount of (meth)acrylic monomer (i) is 2 to 20 mole-%, based on the total amount of (meth)acrylic compounds with OH functionality. The terminal isocyanate groups are reacted with the free OH groups of the (meth)acrylic compounds.

Details regarding the preparation of the oligomers A can e.g. be inferred from DE-A-2,361,041. Possibly present unreacted isocyanate groups are quenched by reaction with an alcohol.

The triisocyanates of formula (VII) have a biuret structure 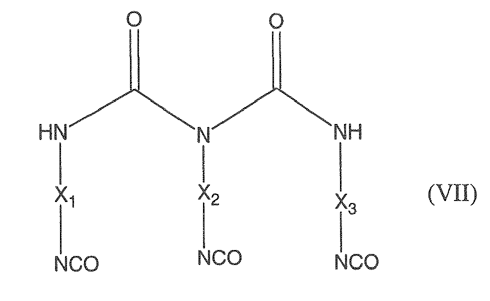 wherein X₁, X₂ and X₃ are independently selected from aliphatic or cycloaliphatic C₄-C₁₂ spacers, araliphatic C₈-C₁₂ spacers and aromatic C₆-C₁₀ spacers, preferably aliphatic and cycloaliphatic C₄-C₁₂-Spacern; preferably X₁ = X₂ = X₃ = hexamethylene.

The triisocyanates of formula (VIII) have a cyanuric acid core 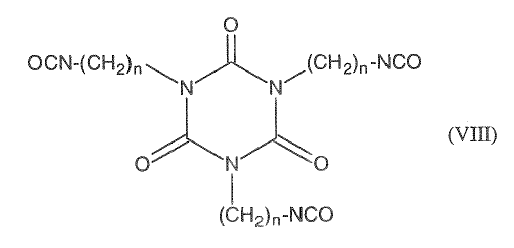 wherein each n is independently an integer from 1 to 10, preferably 2 to 8, and especially preferred 6; preferably, all variables n in formula (VIII) are the same.

The triisocyanates (IX) are aromatic or aliphatic triisocyanates of formulas (IX-1) to (IX-7) 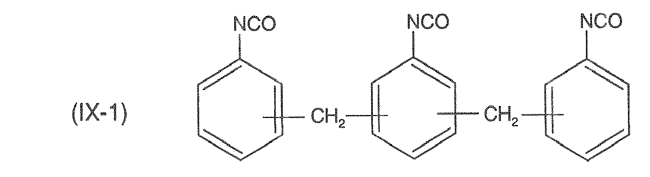 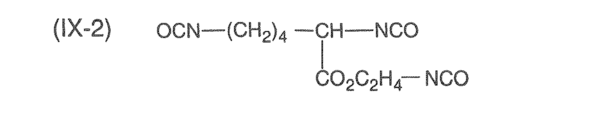 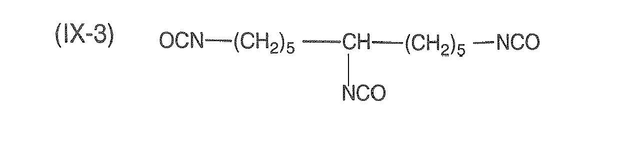 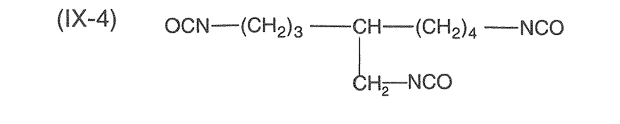 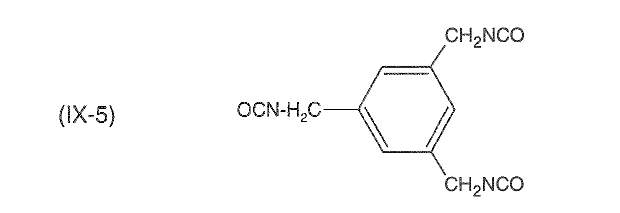 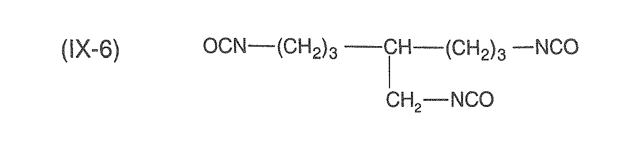 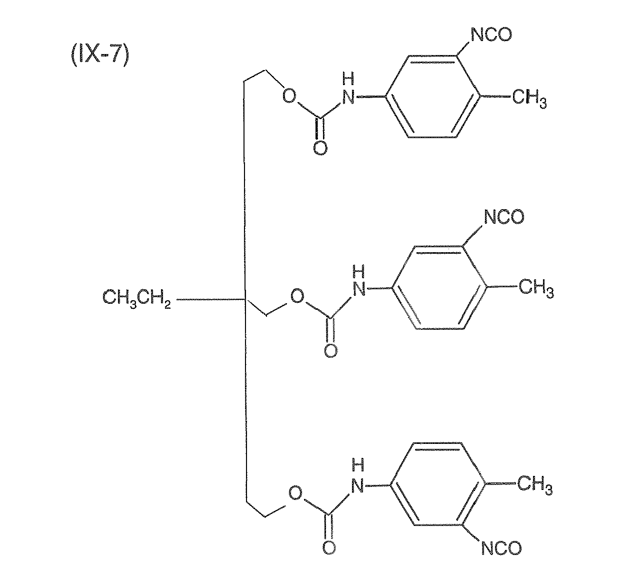 All partial or trivalent or polyhydric alcohols with acrylic acid or methacrylic acid which still have two free OH groups can for example be used as (meth)acrylic monomers (i) with two OH groups and at least one (meth)acrylic group.

Suitable examples include pentaerythritol di(meth)acrylate, glycerin mono(meth)acrylate, trimethylolpropane mono(meth)acrylate, trimethylolethane mono(meth)acrylate, trimethylolbutane mono(meth)acrylate, sorbitol tetra(meth)acrylate, reaction product of bisphenol-A-diglycidylether and (meth)acrylic acid.

Partial esters of bivalent or polyhydric alcohols with poly(alkyleneoxide) chains and (meth)acrylic acid which still have one free OH group can for example be used as (meth)acrylic compounds (ii) with one OH group and poly(alkyleneoxide) chains. The poly(alkyleneoxide) chains are preferably C₂-C₆ alkyleneoxide chains, especially preferred polyethyleneoxide and polypropyleneoxide chains with a degree of polymerization of at least 3. Suitable examples include poly(ethyleneoxide) mono(meth)acrylate, poly(propyleneoxide) mono(meth)acrylate, statistical copolymers or block copolymers of propyleneoxide and ethyleneoxide, esterified with (meth)acrylic acid at one end, ethoxylated and/or propoxylated glycerin, doubly esterified with (meth)acrylic acid.
All partial esters of divalent or polyhydric alcohols with acrylic acid or methacrylic acid which still have one free OH group can for example be used as optional (meth)acrylic monomers (iii) without poly(alkyleneoxide) chains with at least one (meth)acrylic group and only one OH group.

Suitable examples include pentaerythritol tri(meth)acrylate, glycerin di(meth)acrylate, trimethylolpropane di(meth)acrylate, trimethylolethane di(meth)acrylate, trimethylolbutane di(meth)acrylate, trimethylolbutane di(meth)acrylate, sorbitol penta(meth)acrylate.

Ethoxylated and/or propoxylated glycerin mono-esterified with (meth)acrylic acid can optionally be used as well.

For cost the use of a technical mixture of (meth)acrylates as component (i) can be considered; examples thereof include
- glycerin di(meth)acrylate comprising up to 15 wt.-% glycerin mono(meth)acrylate and furthermore up to 40 wt.-% glycerin tri(meth)acrylate;
- trimethylolpropane di(meth)acrylate, comprising up to 15 wt.-% trimethylolpropane mono(meth)acrylate and furthermore up to 40 wt.-% trimethylolpropane tri(meth)acrylate;
- pentaerythritol tri(meth)acrylate, comprising up to 15 wt.-% pentaerythritol di(meth)acrylate and furthermore up to 40 wt.-% pentaerythritol tetra(meth)acrylate.

Numerous other radically polymerizable compounds are known to those skilled in the art and are described in considerable literature including Photoreactive Polymers: The Science and Technology of Resists, A Reiser, Wiley, New York, 1989, pp. 102-177, by B.M. Monroe in Radiation Curing: Science and Technology, S.P. Pappas, Ed., Plenum, New York, 1992, pp. 399-440, and in "Polymer Imaging" by A.B. Cohen and P. Walker, in Imaging Processes and Material, J.M. Sturge et al. (Eds.), Van Nostrand Reinhold, New York, 1989, pp. 226-262. For example, useful radically polymerizable components are also described in EP 1 182 033 A1, beginning with paragraph [0170].

It is of course possible to use a mixture of different kinds of monomers, or different kinds of oligomers or different kinds of polymers in the radiation-sensitive composition; furthermore, mixtures of monomers and oligomers and/or polymers can be used in the present invention, as well as mixtures of oligomers and polymers.

The free-radical polymerizable component is preferably present in an amount of 5 to 95 wt.-% based on the total weight of solids of the composition; if monomers/oligomers are used, especially preferred are 20 to 85 wt.-%, based on the solid content of the radiation-sensitive composition of the present invention.

### Initiator

An initiator as referred to in the present invention is a compound that is essentially unable to absorb when irradiated but forms free radicals together with the radiation-absorbing sensitizers used in the present invention.

The radiation-sensitive composition according to the invention includes an onium tetraarylborate as initiator that is capable of generating radicals sufficient to initiate polymerization of the radically polymerizable component upon exposure of the composition to imaging radiation. The onium cation is selected from diaryliodonium, triarylsulfonium, diazonium, phosphonium, and N-heterocyclic onium cations wherein N is substituted with -OR (R is an optionally substituted hydrocarbyl group).

The diaryliodonium borate initiators are preferably represented by the following formula (X): 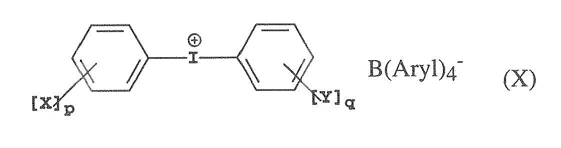 wherein X and Y are independently halogen atoms (for example, fluoro, chloro, or bromo), substituted or unsubstituted alkyl groups having 1 to 20 carbon atoms (for example, methyl, chloromethyl, ethyl, 2-methoxyethyl, *n*-propyl, *iso*propyl, *iso*butyl, *n*-butyl, *t*-butyl, all branched and linear pentyl groups, 1-ethylpentyl, 4-methylpentyl, all hexyl isomers, all octyl isomers, benzyl, 4-methoxybenzyl, *p*-methylbenzyl, all dodecyl isomers, all icosyl isomers, and substituted or unsubstituted mono-and poly-, branched and linear haloalkyls), substituted or unsubstituted alkoxy having 1 to 20 carbon atoms (for example, substituted or unsubstituted methoxy, ethoxy, *iso*-propoxy, *t*-butoxy, (2-hydroxytetradecyl)oxy, and various other linear and branched alkoxy groups), substituted or unsubstituted aryl groups having 6 or 10 carbon atoms in the carbocyclic aromatic ring (such as substituted or unsubstituted phenyl and naphthyl groups including mono- and polyhalophenyl and naphthyl groups), or substituted or unsubstituted cycloalkyl groups having 3 to 8 carbon atoms in the ring structure (for example, substituted or unsubstituted cyclopropyl, cyclopentyl, cyclohexyl, 4-methylcyclohexyl, and cyclooctyl groups). Preferably, X and Y are independently substituted or unsubstituted alkyl groups having 1 to 8 carbon atoms, alkoxy groups having 1 to 8 carbon atoms, or cycloalkyl groups having 5 or 6 carbon atoms in the ring, and more preferably, X and Y are independently substituted or unsubstituted alkyl groups having 3 to 6 carbon atoms (and particularly branched alkyl groups having 3 to 6 carbon atoms). Thus, X and Y can be the same or different groups, the various X groups can be the same or different groups, and the various Y groups can be the same or different groups. Both "symmetric" and "asymmetric" diaryliodonium borate compounds are contemplated by this invention but the "symmetric" compounds are preferred (that is, they have the same groups at the same position on both phenyl rings).

In addition, two or more adjacent X or Y groups can be combined to form a fused carbocyclic or heterocyclic ring with the respective phenyl groups.

The X and Y groups can be in any position on the phenyl rings but preferably they are at the 2-or 4-positions, and more preferably at the 4-position, on either or both phenol rings.

According to one embodiment the sum of the carbon atoms in the X and Y substituents is at least 2, and preferably at least 6, and up to 40 carbon atoms. Thus, in some compounds, one or more X groups can comprise at least 2 carbon atoms, and Y does not exist (q is 0). Alternatively, one or more Y groups can comprise at least 2 carbon atoms, and X does not exist (p is 0). Moreover, one or more X groups can comprise less than 2 carbon atoms and one or more Y groups can comprise less than 2 carbon atoms as long as the sum of the carbon atoms in both X and Y is at least 2. Still again, there may be a total of at least 6 carbon atoms on both phenyl rings. In formula (X), p and q are independently 0 or integers of 1 to 5. Preferably either p or q is at least 1, more preferably, both p and q are at least 1, and most preferably, each of p and q is 1. Thus, it is understood that the carbon atoms in the phenyl rings that are not substituted by X or Y groups have a hydrogen atom at those ring positions.

The borate anion of the iodonium initiator is represented by the following formula (XI):

B(Aryl)₄⁻ (XI)

wherein each "Aryl" independently represents a substituted or unsubstituted carbocyclic aryl group with one or more rings having a total of 6 to 10 ring carbon atoms in the aromatic ring(s) (e.g. phenol, *p*-methylphenyl, 2,4-methoxyphenyl, naphthyl, and pentafluorophenyl groups) or a substituted or unsubstituted heteroaromatic group with 5 to 10 ring atoms, wherein at least one of the ring atoms is a hetero atom selected from N, O and S (e.g. imidazolyl, pyridinyl, quinolinyl, indolyl, pyrimidinyl, pyrazinyl, pyridazolyl, isothiazolyl, thiazolyl, oxazolyl, isoxazolyl); according to one embodiment all "Aryl" substituents are the same and it is preferred that the borate anion comprises 4 substituted or unsubstituted phenyl groups. It is especially preferred that the borate anion is B(phenyl)₄⁻.

Representative iodonium borate compounds useful in this invention include but are not limited to, 4-octyloxyphenyl phenyliodonium tetraphenylborate, [4-[(2-hydroxytetradecyl)-oxy]-phenyl]phenyliodonium tetraphenylborate, bis(4-*t*-butylphenyl)iodonium tetraphenyl-borate, bis(4-isopropylphenyl)iodonium tetraphenylborate, 4-methylphenyl-4'-hexylphenyliodonium tetraphenylborate, 4-methylphenyl-4'-cyclohexylphenyliodonium tetraphenylborate, bis(*t-*butylphenyl)iodonium tetrakis-(pentafluorophenyl)borate, 4-hexylphenyl-phenyliodonium tetraphenylborate, 4-cyclohexylphenyl-phenyliodonium tetraphenylborate, 2-methyl-4-*t-*butylphenyl-4'-methylphenyliodonium tetraphenylborate, 4-methylphenyl-4'-pentylphenyl-iodonium tetrakis[3,5-bis(trifluoromethyl)phenyl]-borate, 4-methoxyphenyl-4'-cyclohexyl-phenyliodonium tetrakis(penta-fluorophenyl)borate, 4-methylphenyl-4'-dodecylphenyl-iodonium tetrakis(4-fluorophenyl)borate, bis(dodecylphenyl)iodonium tetrakis(pentafluorophenyl)borate, and bis(4-*t*-butylphenyl)iodonium tetrakis(1-imidazolyl)borate. Preferred compounds include bis(4-*t*-butylphenyl)iodonium tetraphenylborate, bis(4-isopropylphenyl)iodonium tetraphenylborate, 4-methylphenyl-4'-hexylphenyliodonium tetraphenylborate, 2-methyl-4-*t*-butylphenyl-4'-methylphenyliodonium tetraphenylborate, and 4-methylphenyl-4'-cyclohexylphenyliodonium tetraphenylborate. Mixtures of two or more of these compounds can also be used as iodonium borate initiator.

The diaryliodonium borate compounds can be prepared, in general, by reacting an aryl iodide with a substituted or unsubstituted arene, followed by an ion exchange with a borate anion. Details of various preparatory methods are described in U.S. Patent 6,306,555 (Schulz et al.), and references cited therein, and by Crivello, J.Polymer Sci., Part A: Polymer Chemistry, 37, 4241-4254 (1999).

Another class of onium initiators useful for the present invention are N-heterocyclic onium tetraarylborates wherein the nitrogen atom of the N-heterocyclic onium cation is substituted with -OR wherein R is an optionally substituted saturated or unsaturated hydrocarbyl group; R is for instance selected from optionally substituted alkyl, cycloalkyl, alkenyl, alkynyl, aralkyl, and aryl groups, preferably from optionally substituted alkyl or aryl groups, more preferably from optionally substituted alkyl groups. The N-heterocyclic onium moiety is preferably selected from pyridinium, indolium, quinolinium, isoquinolmium, most preferably it is pyridinium. If R is an alkyl group it is preferably an optionally substituted C₁-C₂₀-alkyl (more preferably optionally substituted C₁-C₁₂ straight-chain alkyl or C₃-C₁₂ branched alkyl); unsubstituted alkyl groups are especially preferred. If R is an cycloalkyl it is preferably a cycloalkyl group having 5 to 10 carbon atoms. Specific examples of suitable alkyl und cycloalkyl groups include methyl, ethyl, proypyl, butyl, pentyl, hexyl, heptyl, octyl, nonyl, decyl, undecyl, dodecyl, tridecyl, hexadecyl, octadecyl, eicosyl, isopropyl, isobutyl, s-butyl, t-butyl, isopentyl, neopentyl, 1-methylbutyl, isohexyl, 2-ethylhexyl, 2-methylhexyl, cyclohexyl, cyclopentyl, and 2-norbornyl groups.

When the alkyl or cycloalkyl group is substituted the substituent(s) is/are preferably selected from halogen, alkoxy, aryl, aryloxy, alkylthio, arylthio, amino.

Preferable specific examples of substituted alkyl groups include chloromethyl, bromomethyl, 2-chloroethyl, trifluoromethyl, methoxymethyl, isopropoxymethyl, butoxymethyl, s-butoxybutyl, methoxyethoxyethyl, benzyl, phenoxymethyl, methylthiomethyl, tolylthiomethyl, methoxyethyl, ethylaminoethyl, and diethylaminopropyl.

If R is an alkenyl it is preferably an alkenyl group having 2 to 20 carbon atoms. Among them, alkenyl groups having 2 to 10 carbon atoms are more preferable, and alkenyl groups having 2 to 8 carbon atoms are most preferable. The alkenyl group may have one or more substituents. Examples of the substituent that may be introduced include halogen, alkyl, cycloalkyl and aryl; and halogen atoms, and straight-chain, branched-chain, and cyclic alkyl groups having up to 10 carbon atoms are preferable. Specific examples of the alkenyl groups include vinyl, 1-propenyl, 1-butenyl, cinnamyl, 1-pentenyl, 1-hexenyl, 1-octenyl, 1-methyl-1-propenyl, 2-methyl-1-propenyl, 2-methyl-1-butenyl, 2-phenyl-1-ethenyl, and 2-chloro-1-ethenyl groups.

Examples of the alkynyl groups represented by R include alkynyl groups having 2 to 20 carbon atoms. Among them, alkynyl groups having 2 to 10 carbon atoms are preferable, and alkynyl groups having 2 two 8 carbon atoms are more preferable. Specific examples thereof include ethynyl, 1-propynyl, 1-butynyl, phenylethynyl, and trimethylsilylethynyl groups.

Examples of the aryl groups represented by R include a benzene ring, fused rings of 2 to 3 benzene rings, fused rings of a benzene ring and a five-membered unsaturated ring, and the like. Specific examples thereof include phenyl, naphthyl, anthryl, phenanthryl, indenyl, acenaphthenyl, and fluorenyl groups; and among them, phenyl and naphthyl groups are more preferable.

In addition, the aryl group represented by R may have one or more substituents and examples thereof are those described for the substituents of alkyl above; if R is an aryl it is preferably an unsubstituted aryl.

Especially preferred N-heterocyclic onium cations are N-alkoxy-pyridinium cations.

The tetraarylborate counter anion for the N-heterocyclic onium is as defined above for the diaryliodonium salts.
The preferred pyridinium and isoquinolinium cations are represented by the following formulae (XII) and (XIII) 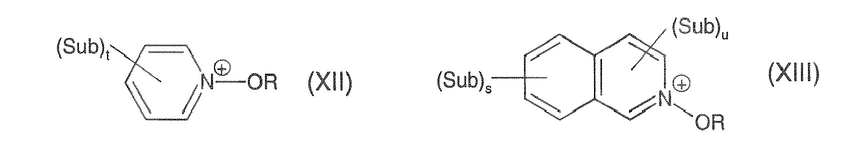 wherein R is as defined above for the N-substituted N-heterocyclic onium cation; "Sub" represents optional substituents selected from halogen, optionally substituted alkyl, aryl, alkoxy, aryloxy, alkylthio and arylthio; t is 0 or an integer from 1 to 5, s is 0 or an integer from 1 to 4 and u is 0 or an integer from 1 to 3.

Examples of useful N-heterocyclic onium cations are for instance the following pyridinium cations:

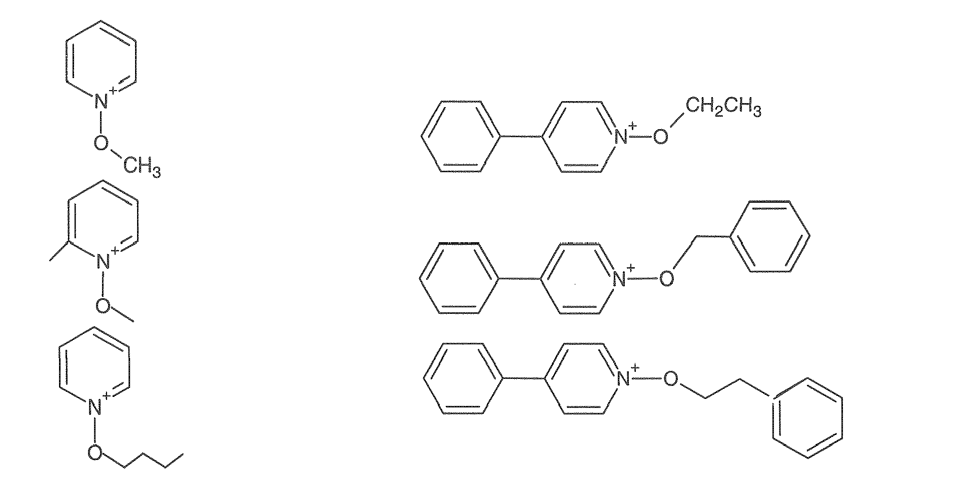

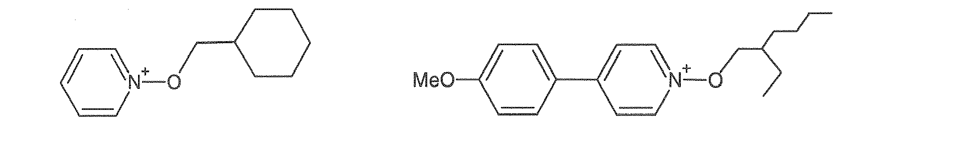

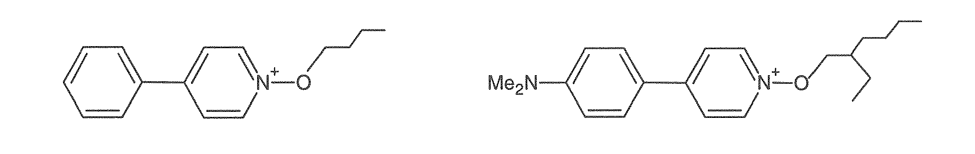

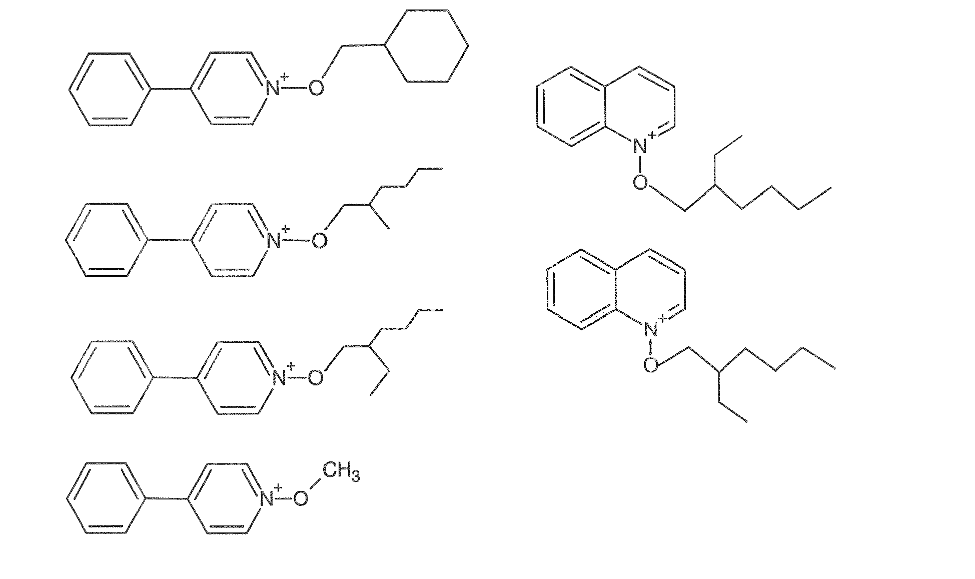

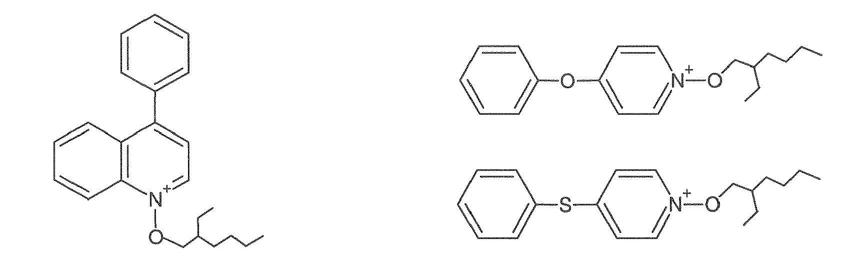

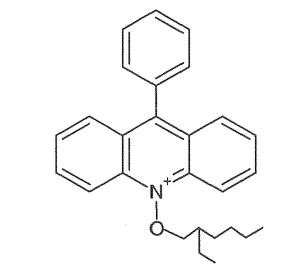

Suitable pyridinium cations are for instance disclosed in EP 1 803 556 A1 and J. Polym. Sci. Part A: Polymer Chem. 1992, 30, 1987 and Polymer 1993, 34(6), 1130.

A further class of suitable initiators are triarylsulfonium tetraarylborates S(Ar)₃^{⊕} B(Aryl)₄⁻ wherein the tetraarylborate anion is as defined above for the iodonium initiator and the 3 "Ar" substituents of the sulfonium cation can be the same or different aromatic substituents selected from optionally substituted C₅-C₁₀-aryl and optionally substituted C₅-C₁₀-heteroaryl containing 1 to 3 heteroatoms selected from N, S and O; suitable substituents for the aryl group are for instance halogen, nitro, C₁-C₁₂-alkyl, C₁-C₁₂-alkoxy and aryloxy; and suitable substituents for the heteroaryl group are for instance halogen, C₁-C₁₂-alkyl, C₁-C₁₂-alkoxy and aryloxy.

Examples of useful triarylsulfonium tetraarylborates are triphenylsulfonium tetraarylborates, tris(4-chlorophenyl)sulfonium tetraarylborate and tris(4-iso-propyl-phenyl)sulfonium tetraarylborates.

Another class of suitable initiators are phosphonium tetraarylborates of formula (XIV) 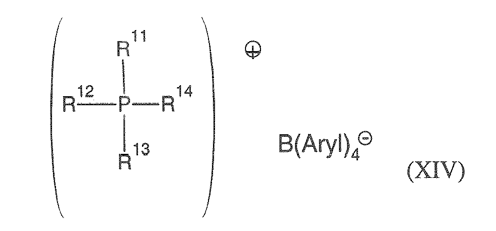 wherein R¹¹ to R¹⁴ independently represent optionally substituted alkyl (preferably C₁-C₂₀), alkenyl (preferably C₂-C₁₅), alkynyl (preferably C₂-C₁₅), cycloalkyl (preferably C₃-C₈), alkoxy (preferably C₁-C₂₀), aryl, aryloxy, alkylthio (preferably C₁-C₂₀), arylthio, or heterocyclyl or a hydrogen atom, or at least two of R¹¹ to R¹⁴ may be combined with each other to form a ring provided that at least one of R¹¹ to R¹⁴ is different from H. Examples of the aryl include phenyl and naphthyl, examples of aryloxy include phenoxy and naphtoxy, examples of arylthio include phenylthio, and examples of the heterocyclic group include furyl and thienyl. Examples of the optional substituent of these groups R¹¹ to R¹⁴ include alkyl, alkenyl, alkynyl, cycloalkyl, alkoxy, alkoxycarbonyl, acyl, alkylthio, aryl, aryloxy, arylthio, sulfino, sulfo, phosphino, phosphoryl, amino, nitro, cyano, hydroxy, and halogen.

Examples of useful phosphonium cations are:

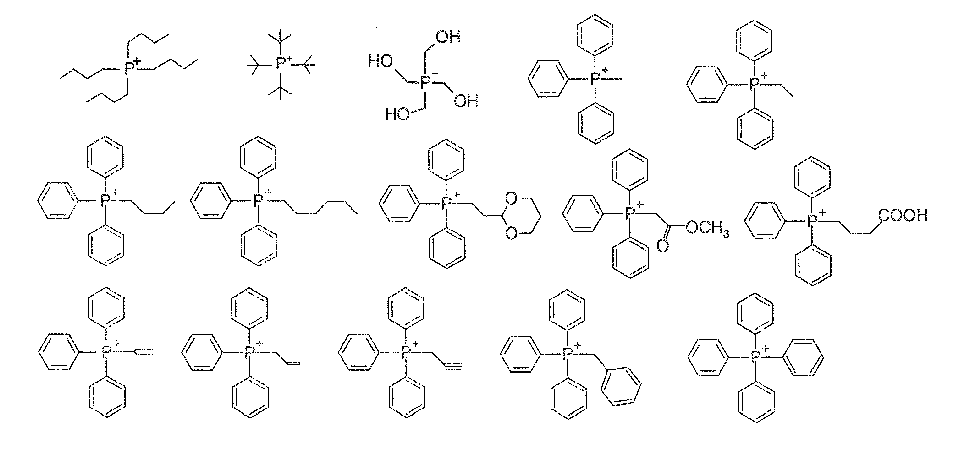

The tetraarylborate anion of the phosphonium compounds is as defined above for the iodonium compounds.

The initiator used in the present invention can also be a diazonium tetraarylborate

Ar-N^{⊕}≡N B(Aryl)₄⁻ (XV)

wherein "Ar" is as defined above for the sulfonium compounds and "B(Aryl)₄⁻ is as defined above for the iodonium compounds.

Examples of useful diazonium cations are for instance:

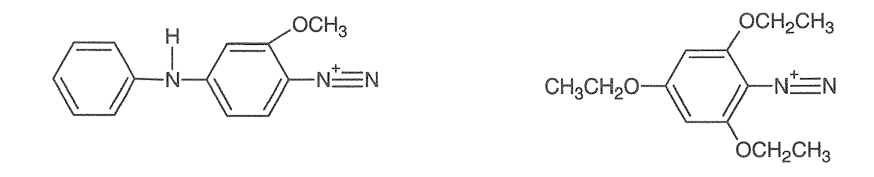

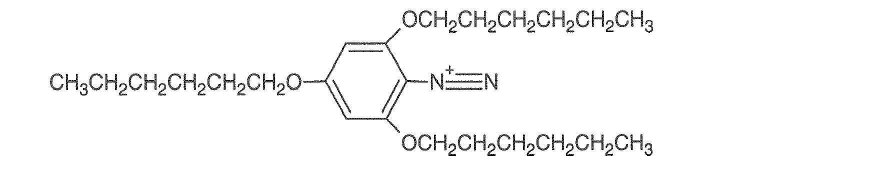

The amount of the onium borate initiator is not particularly restricted, however, the initiator is generally present in the radiation-sensitive composition in an amount of at least 0.05% and up to 30%, based on the total solids of the radiation-sensitive composition or the dry weight of the coated imageable layer. Preferably, the initiator is present in an amount of from about 0.1% to about 15 weight %.

Either a single initiator or a mixture of two or more can be present; in the latter case, the amounts given refer to the total amount of all initiators.

### Sensitizer

The radiation-sensitive composition furthermore comprises at least one photothermal conversion material (in the following also referred to as "IR absorber" or "sensitizer").

The photothermal conversion material is capable of absorbing IR radiation and converting it into heat or interact with the initiator to form radicals. The chemical structure of the IR absorber is not particularly restricted, as long as it contains an IR absorbing cation and a tetraarylborate anion. It is preferred that the IR absorber shows essential absorption (preferably an absorption maximum) in the range of 700 to 1,200 nm, preferably 750 to 1,120 nm. IR absorbers showing an absorption maximum in the range of 800 to 1,100 nm are especially preferred. It is furthermore preferred that the IR absorber not or not essentially absorbs radiation in the UV range.

The cationic dye is for example selected from cyanine dyes, triarylmethane-based dyes, ammonium-based dyes and diimmonium-based dyes.

According to a preferred embodiment, a cyanine dye of formula (XVI) is used 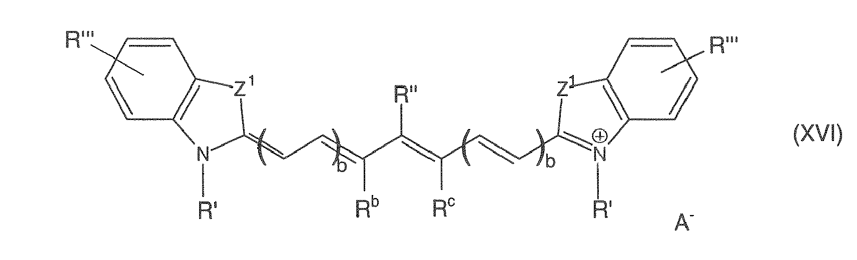 wherein
- each Z¹: independently represents S, O, NR^{a} or C(alkyl)₂;
- each R': independently represents an alkyl group, or an alkylammonium group;
- R": represents a halogen atom, SR^{a}, OR^{a}, SO₂R^{a} or NR^{a}₂;
- each R"': independently represents a hydrogen atom, an alkyl group, -COOR^{a}, -OR^{a}, -SR^{a}, -NR^{a}₂ or a halogen atom; R"' can also be a benzofused ring;
- R^{b} and R^{c}: either both represent hydrogen atoms or, together with the carbon atoms to which they are bonded, form a carbocyclic five- or six-membered ring;
- R^{a}: represents a hydrogen atom, an alkyl or aryl group;
- each b: is independently 0, 1, 2 or 3; and
- A⁻: is a tetraarylborate anion B(Aryl)₄⁻ wherein "Aryl" is as defined above with respect to the tetraarylborate of the onium initiator.

If R' represents an alkylammonium group, a second counterion is needed which is also a tetraarylborate and preferably the same as A⁻.
- Z¹: is preferably a C(alkyl)₂ group.
- R': is preferably an alkyl group with 1 to 4 carbon atoms.
- R": is preferably a halogen atom or SR^{a} or NR^{a}₂.
- R"': is preferably a hydrogen atom.
- R^{a}: is preferably an optionally substituted phenyl group or an optionally substituted heteroaromatic group.

Preferably, R^{b} and R^{c}, together with the carbon atoms to which they are bonded, form a 5- or 6-membered carbocyclic ring.

Of the IR dyes of formula (XVI), dyes with a symmetrical structure are especially preferred. Examples of especially preferred cationic dyes include:
2-[2-[2-Phenylsulfonyl-3-[2-(1,3-dihydro-1,3,3-trimethyl-2H-indole-2-ylidene)-ethylidene]-l-cyclobexene-1-yl]-ethenyl]-1,3,3-trimethyl-3H-indolium,
2-[2-[2-thiophenyl-3-[2-(1,3-dihydro-1,3,3-trimethyl-2H-indole-2-ylidene)-ethylidene]-1-cyclohexene-1-yl]-ethenyl]-1,3,3-trimethyl-3H-indolium,
2-[2-[2-thiophenyl-3-[2-(1,3-dihydro-1,3,3-trimethyl-2H-indole-2-ylidene)-ethylidene]-1-cyclopentene-1-yl]-ethenyl]-1,3,3-trimethyl-3H-indolium,
2-[2-[2-chloro-3-[2-(1,3-dihydro-1,3,3-trimethyl-2H-benzo[e]-indole-2-ylidene)-ethylidene]-1-cyclohexene-1-yl]-ethenyl]-1,3,3-trimethyl-1H-benzo[e]-indolium and
2-[2-[2-chloro-3-[2-ethyl-(3H-benzthiazole-2-ylidene)-ethylidene]-1-cyclohexene-1-yl]-ethenyl]-3-ethyl-benzthiazolium.

The following compounds are also IR absorbers suitable for use in the present invention (with A⁻ being a tetraarylborate anion as defined above):

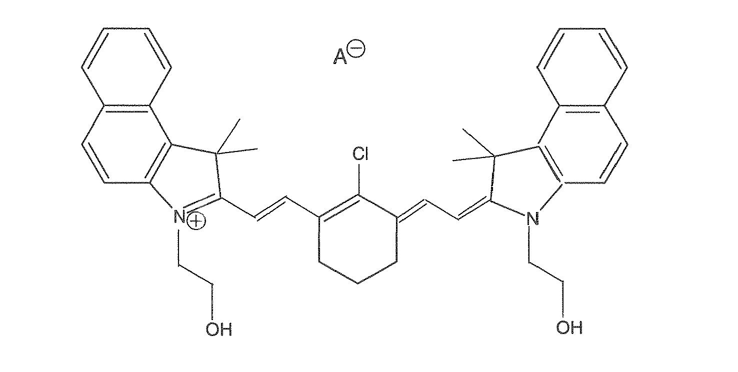

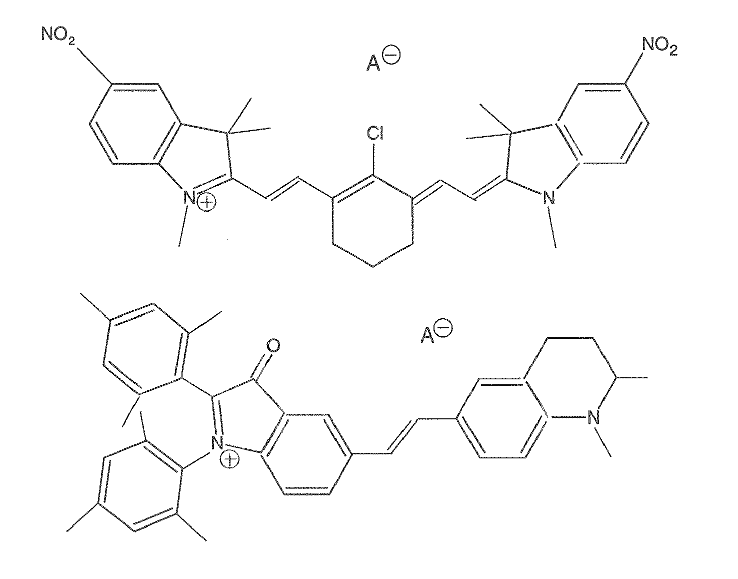

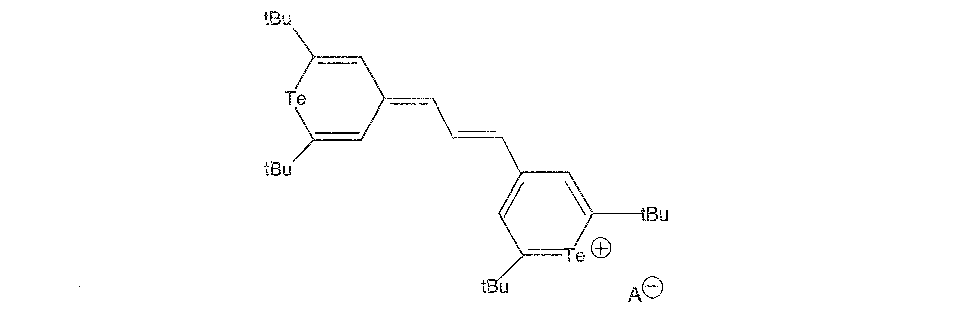

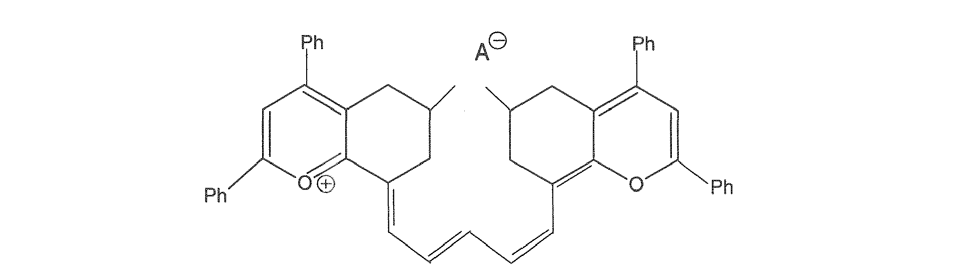

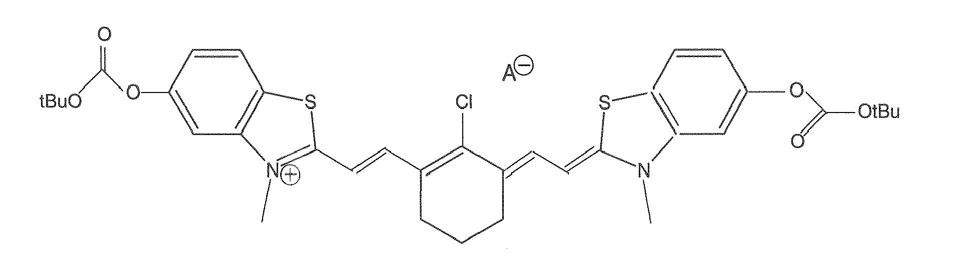

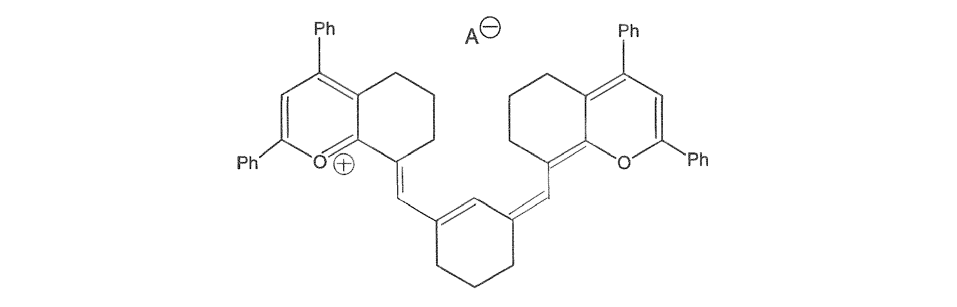

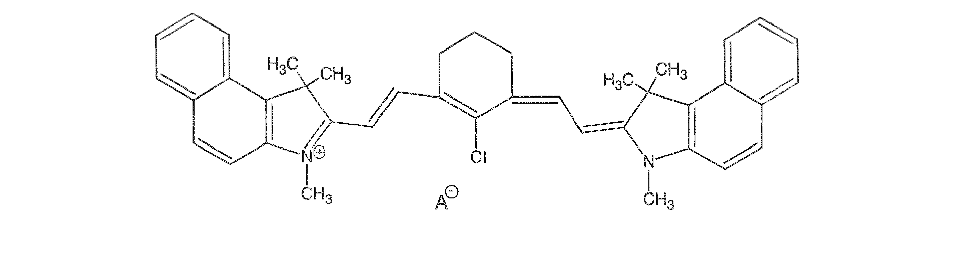

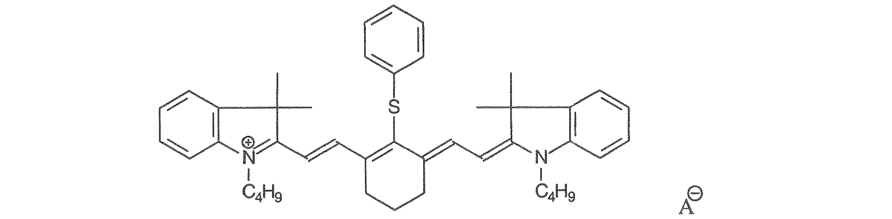

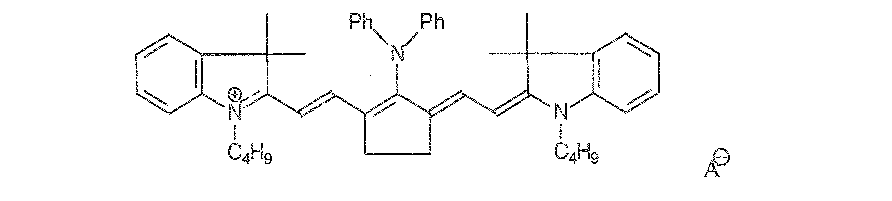

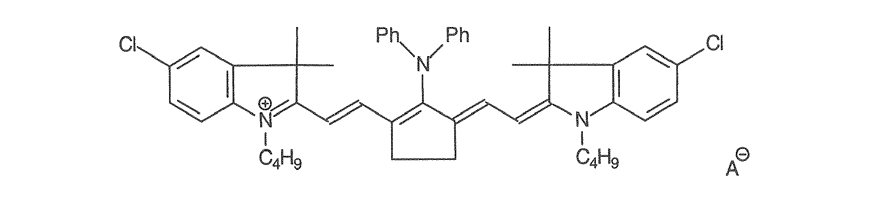

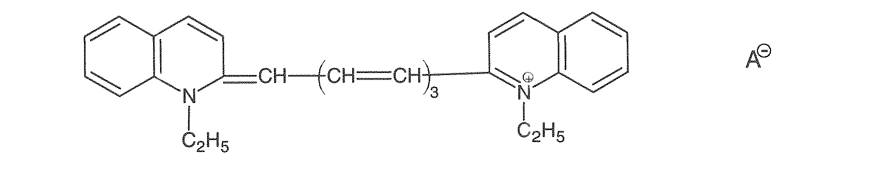

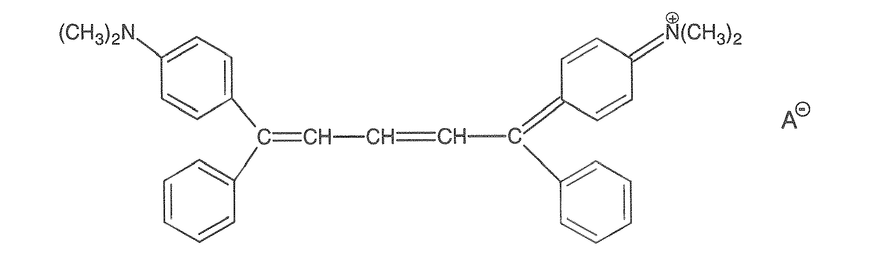

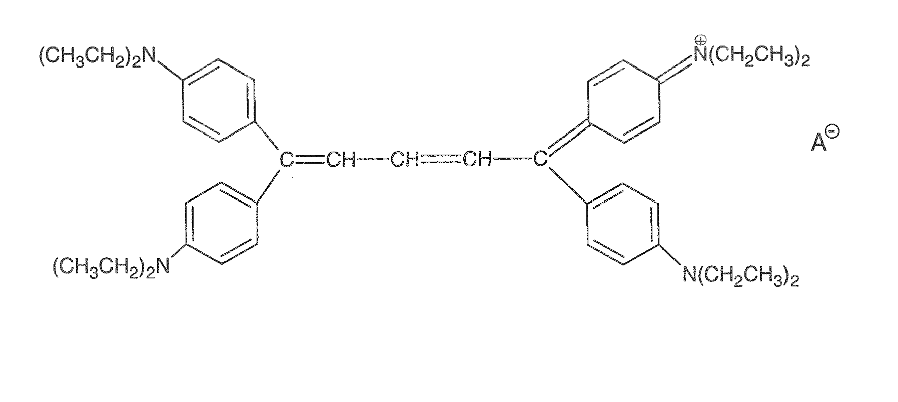

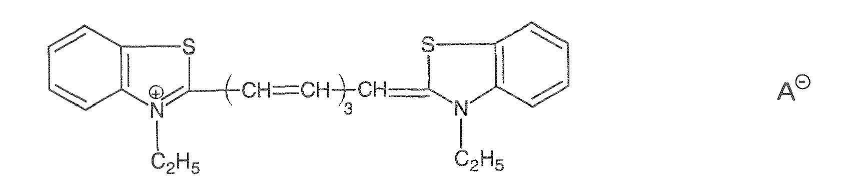

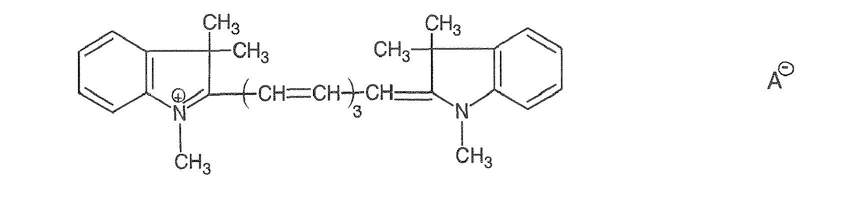

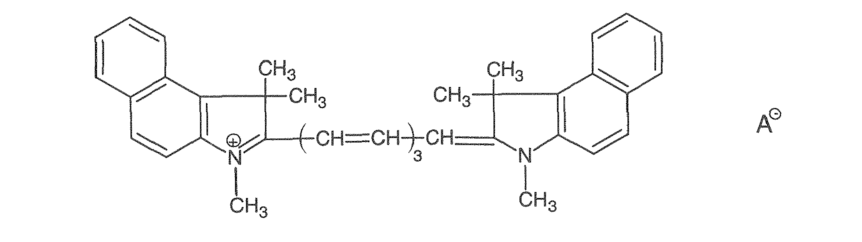

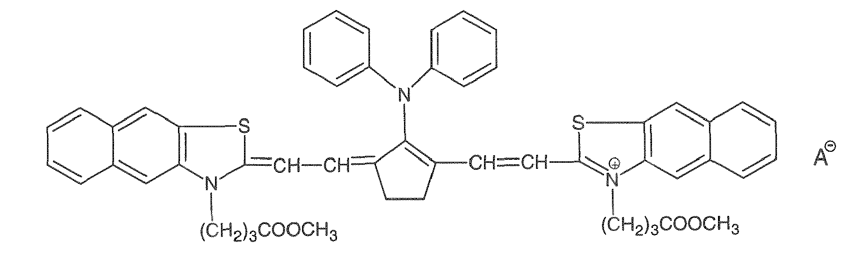

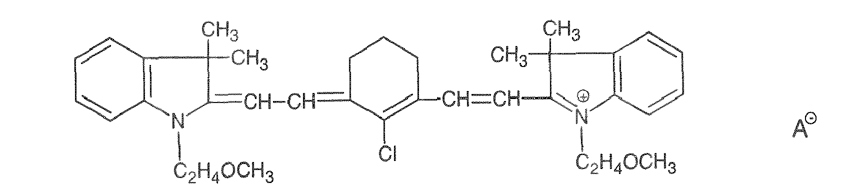

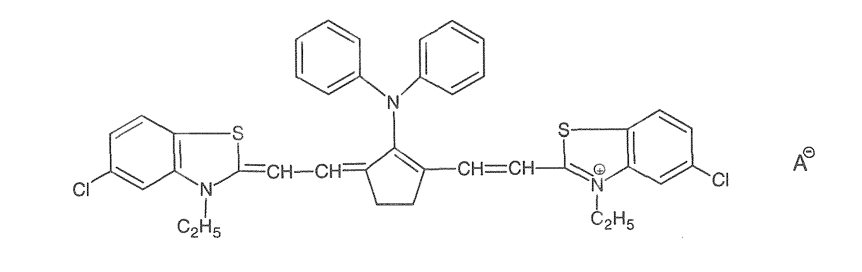

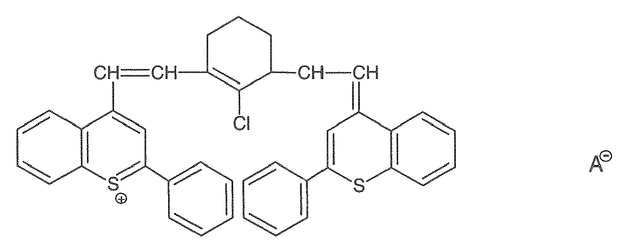

The amount of IR absorber in the imageable layer is preferably at least 1 wt.-% based on the dry layer weight (or the solids of the radiation-sensitive composition), more preferably at least 3 wt.-%, most preferably at least 5 wt.-%. Usually, the amount of IR absorber does not exceed 50 wt.-%, preferably 30 wt.-% and most preferably 20 wt.-% based on the dry layer weight (or the solids of the radiation-sensitive composition). Either a single IR absorber or a mixture of two or more can be present; in the latter case, the amounts given refer to the total amount of all IR absorbers.

### Optional polymeric binder

Any of a variety of polymeric binders can be used in the radiation-sensitive composition, including those known in the art for use in negative-working radiation-sensitive compositions. The polymeric binders generally have a molecular weight of from about 2,000 to about 1,000,000 and preferably from about 10,000 to about 200,000. The acid value of (mg KOH/g) the polymeric binder is generally from about 5 to about 400 as determined using known methods.

Some binders are water-insoluble but soluble in a developer having a pH of 4 to 14. Examples of such polymeric binders include but are not limited to, (meth)acrylic acid ester resins, polyvinyl acetals, phenolic resin, polymers derived from styrene, N-substituted cyclic imides or maleic anhydrides, such as those described in U.S. Patents 6,309,792, 6,352,812 (Shimazu et al.), 6,569,603, and 6,893,797. Also useful are the vinyl carbazole polymers having pendant N-carbazole moieties as described in copending and commonly assigned U.S.S.N. 11/356,518 and the polymers having pendant vinyl groups as described in copending and commonly assigned 11/349,376.

Other useful polymeric binders include but are not limited to those having one or more ethylenically unsaturated pendant groups (reactive vinyl groups) attached to the polymer backbone. Such reactive groups are capable of undergoing polymerizable or crosslinking in the presence of free radicals. The pendant groups can be directly attached to the polymer backbone with a carbon-carbon direct bond, or through a linking group ("X") that is not particularly limited. The reactive vinyl groups may be substituted with at least one halogen atom, carboxy group, nitro group, cyano group, amide group, or alkyl, aryl, alkoxy, or aryloxy group, and particularly one or more alkyl groups. In some embodiments, the reactive vinyl group is attached to the polymer backbone through a phenylene group as described, for example, in U.S. Patent 6,569,603 (Furukawa et al.). Still other useful polymeric binders have vinyl groups in pendant groups that are described, for example in EP 1,182,033A1 (Fujimaki et al.) and U.S. Patents 4,874,686 (Urabe et al.) and 7,041,416 (Wakata et al.) that are incorporated by reference, especially with respect to the general formulae (1) through (3) noted in EP 1,182,033A1. Some useful pendant reactive vinyl groups are alkenyl groups including but not limited to allyl esters, styryl, and (meth)acryloyl groups. For example, such groups can be provided by allyl (meth) acrylates, or by reacting a polymer precursor with an allyl halide, 4-vinylbenzyl chloride, or (meth)acryloyl chloride using conditions that would be apparent to a skilled worker in the art.

Other useful polymeric binders are dispersible, developable, or soluble in water or water/solvent mixtures such as fountain solutions. Such polymeric binders include polymeric emulsions, dispersions, or graft polymers having pendant poly(alkyleneoxide) side chains that can render the imageable elements as "on-press" developable. Such polymeric binders are described for example in U.S. Patents 6,582,882 and 6,899,994. In some instances, these polymeric binders are present in the imageable layer as discrete particles.

Other useful polymeric binders are described in copending and commonly assigned U.S.S.N. 11/196,124 and have hydrophobic backbones and comprise both of the following a) and b) recurring units, or the b) recurring units alone:
a) recurring units having pendant cyano groups attached directly to the hydrophobic backbone, and
b) recurring units having pendant groups comprising poly(alkylene oxide) segments.

These polymeric binders comprise poly(alkylene oxide) segments and preferably poly(ethylene oxide) segments. These polymers can be graft copolymers having a main chain polymer and poly(alkylene oxide) pendant side chains or segments of block copolymers having blocks of (alkylene oxide)-containing recurring units and non(alkylene oxide)-containing recurring units. Both graft and block copolymers can additionally have pendant cyano groups attached directly to the hydrophobic backbone. The alkylene oxide constitutional units are generally C₁ to C₆ alkylene oxide groups, and more typically C₁ to C₃ alkylene oxide groups. The alkylene portions can be linear or branched or substituted versions thereof. Poly(ethylene oxide) and poly(propylene oxide) segments are preferred and poly(ethylene oxide) segments are most preferred.

In some embodiments, the polymeric binders contain only recurring units comprising poly(alkylene oxide) segments, but in other embodiments, the polymeric binders comprise recurring units comprising the poly(alkylene oxide) segments as well as recurring units having pendant cyano groups attached directly to the hydrophobic backbone. By way of example only, such recurring units can comprise pendant groups comprising cyano, cyano-substituted alkylene groups, or cyano-terminated alkylene groups. Recurring units can also be derived from ethylenically unsaturated polymerizable monomers such as acrylonitrile, methacrylonitrile, methyl cyanoacrylate, ethyl cyanoacrylate, or a combination thereof. However, cyano groups can be introduced into the polymer by other conventional means. Examples of such cyano-containing polymeric binders are described for example in U.S. Patent Application Publication 2005/003285 (Hayashi et al.).

By way of example, such polymeric binders can be formed by polymerization of a combination or mixture of suitable ethylenically unsaturated polymerizable monomers or macromers, such as:
A) acrylonitrile, methacrylonitrile, or a combination thereof,
B) poly(alkylene oxide) esters of acrylic acid or methacrylic acid, such as poly(ethylene glycol) methyl ether acrylate, poly(ethylene glycol) methyl ester methacrylate, or a combination thereof, and
C) optionally, monomers such as acrylic acid, methacrylic acid, styrene, hydroxystyrene, acrylate esters, methacrylate esters, acrylamide, methacrylamide, or a combination of such monomers.

The amount of the poly(alkylene oxide) segments in such polymeric binders is from about 0.5 to about 60 weight %, preferably from about 2 to about 50 weight %, more preferably from about 5 to about 40 weight %, and most preferably from 5 to 20 weight %. The amount of (alkylene oxide) segments in the block copolymers is generally from about 5 to about 60 weight %, preferably from about 10 to about 50 weight %, and more preferably from about 10 to about 30 weight %. It is also possible that the polymeric binders having poly(alkylene oxide) side chains are present in the form of discrete particles.

The polymeric binders described above are preferably present in an amount of from about 10 to about 70%, and preferably from about 20 to about 50%, based on the total solids content of the radiation-sensitive composition, or the dry weight of the imageable layer prepared therefrom.

### Further Optional Additives

Furthermore, the radiation-sensitive composition of the present invention can comprise dyes or pigments for coloring (contrast dyes and pigments). Examples of suitable colorants include e.g. phthalocyanine pigments, azo pigments, carbon black and titanium dioxide, triarylmethane dyes, such as ethyl violet and crystal violet, azo dyes, anthraquinone dyes and cyanine dyes. The amount of colourant is preferably 0 to 20 wt.-%, based on the dry layer weight or the total solid content of the radiation-sensitive composition, especially preferred 0.5 to 10 wt.-%.

For improving the physical properties of the hardened layer, the radiation-sensitive coating can additionally comprise further additives such as plasticizers or inorganic fillers. Suitable plasticizers include e.g. dibutyl phthalate, dioctyl phthalate, didodecyl phthalate, dioctyl adipate, dibutyl sebacate, triacetyl glycerin and tricresyl phosphate. The amount of plasticizer is not particularly restricted, however, it is preferably 0 to 10 wt.-%, based on the dry layer weight, especially preferred 0.25 to 5 wt.-%.

Suitable inorganic fillers include for example Al₂O₃ and SiO₂; they are preferably present in an amount of 0 to 20 wt.-%, based on the dry layer weight, especially preferred 0.1 to 5 wt.-%.

The radiation-sensitive coating can also comprise known chain transfer agents. They are preferably used in an amount of 0 to 15 wt.-%, based on the dry layer weight, especially preferred 0.5 to 5 wt.-%,

Furthermore, the radiation-sensitive coating can comprise leuco dyes such as e.g. leuco crystal violet and leucomalachite green. They are preferably present in an amount of 0 to 10 wt.-%, based on the dry layer weight, especially preferred 0.5 to 5 wt.-%.

Additionally, the radiation-sensitive coating can comprise surfactants (flow improvers). Suitable surfactants include siloxane-containing polymers, fluorine-containing polymers and polymers with ethylene oxide and/or propylene oxide groups. They are preferably present in an amount of 0 to 10 wt.-%, based on the dry layer weight, especially preferred 0.2 to 5 wt.-%.

The radiation-sensitive composition can also include dispersing agents, humectants, biocides, viscosity builders, pH adjusters, drying agents, defoamers, preservatives, antioxidants, development aids, rheology modifiers or combinations thereof, or any other addenda commonly used in the lithographic art, in conventional amounts. Useful viscosity builders include hydroxypropyl cellulose, hydroxyethyl cellulose, carboxymethyl cellulose, and poly(vinyl pyrrolidones).

In some embodiments, the radiation-sensitive composition also includes a mercaptan derivative such as a mercaptotriazole such as 3-mercapto-1,2,4-triazole, 4-methyl-3-mercapto-1,2,4-triazole, 5-mercapto-1-phenyl-1,2,4-triazole, 4-amino-3-mercapto-1,2,4,-triazole, 3-mercapto-1,5-diphenyl-1,2,4-triazole, and 5-(*p*-aminophenyl)-3-inercapto-1,2,4-triazole. Various mercaptobenzimidazoles, mercaptobenzthiazoles, and mercaptobenzoxazoles may also be present.

The radiation-sensitive composition may include one or more thermopolymerization inhibitors such as those described on page 10 (lines 14-22) of WO 2004/074929.

### Imageable Elements

The imageable elements are formed by suitable application of the radiation-sensitive composition described above to a suitable substrate to form an imageable layer. This substrate can be treated or coated in various ways as described below prior to application of the radiation-sensitive composition. Preferably, there is only a single imageable layer comprising the radiation-sensitive composition of this invention. If the substrate has been treated to provide an "interlayer" for improved adhesion or hydrophilicity, the applied radiation-sensitive composition is generally considered the "top" or outermost layer. These interlayers, however, are not considered "imageable layers".

The additional application of a water-soluble oxygen-impermeable overcoat onto the radiation-sensitive layer can be advantageous. The polymers suitable for such an overcoat include, *inter alia*, polyvinyl alcohol, polyvinyl alcohol/polyvinyl acetate copolymers, polyvinyl pyrrolidone, polyvinyl pyrrolidone/polyvinyl acetate copolymers, polyvinyl methylethers, decyclized copolymers of maleic acid anhydride and a comonomer such as methylvinylether, polyacrylic acid, cellulose ether, gelatin, etc.; polyvinyl alcohol is preferred. Preferably, the composition for the oxygen-impermeable overcoat is applied in the form of a solution in water or in a solvent miscible with water; in any case, the solvent is selected such that the radiation-sensitive coating already present on the substrate essentially does not dissolve upon application of the overcoat composition. The layer weight of the overcoat can e.g. be 0.1 to 6 g/m², preferably 0.5 to 4 g/m². In order to improve adhesion of the overcoat to the radiation-sensitive layer, the overcoat can comprise adhesion promoters such as e.g. poly(vinylpyrrolidone), poly(ethyleneimine) and poly(vinylimidazole). Suitable overcoats are described for example in WO 99/06890.

### Substrates

In the production of the radiation-sensitive elements of the present invention, a material in the form of a sheet, film, or foil, which is strong, stable, and flexible and resistant to dimensional change under conditions of use so that color records will register a full-color image is preferably used as a substrate. Examples of such substrates include self-supporting materials such as paper, paper coated with plastic materials (such as polyethylene, polypropylene, or polystyrene), a metal plate or foil, such as e.g. aluminum (including aluminum alloys), zinc and copper plates, plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition. Among these substrates, an aluminum plate or foil is especially preferred for the preparation of lithographic printing plate precursors since it shows a remarkable degree of dimensional stability, is inexpensive and furthermore exhibits excellent adhesion to the coating; furthermore, a composite film can be used wherein an aluminum foil has been laminated onto a polyethylene terephthalate film.

For lithographic printing plate precursors it is necessary that the substrate either has a naturally hydrophilic surface or is subjected to a suitable treatment generating such a surface.

A metal substrate, in particular an aluminum substrate, is preferably subjected to at least one treatment selected from graining (e.g. by brushing in a dry state or brushing with abrasive suspensions, or electrochemical graining, e.g. by means of a hydrochloric acid electrolyte), anodizing (e.g. in sulfuric acid or phosphoric acid) and hydrophilizing, especially if the radiation-sensitive element is a lithographic printing plate precursor. In order to improve the hydrophilic properties of the surface of the metal substrate that has been grained and optionally anodized in sulfuric acid or phosphoric acid, an interlayer can be provided on the metal substrate by subjecting it e.g. to an aftertreatment with an aqueous solution of sodium silicate, calcium zirconium fluoride, polyvinylphosphonic acid or phosphoric acid. Within the framework of the present invention, the term "substrate" also encompasses an optionally pretreated substrate exhibiting, for example, a hydrophilizing layer ("interlayer") on its surface. The details of the above-mentioned substrate pre-treatment are known to the person skilled in the art.

The thickness of the substrate can be varied but should be sufficient to sustain the wear from printing and thin enough to wrap around a printing form. Preferred embodiments include a treated aluminum foil having a thickness of from about 100 to about 600 µm.
The backside (non-imaging side) of the substrate may be coated with antistatic agents and/or slipping layers or a matte layer to improve handling and "feel" of the imageable element.

The substrate can also be a cylindrical surface having the radiation-sensitive composition applied thereon, and thus be an integral part of the printing press. The use of such imaging cylinders is described for example in U.S. Patent 5,713,287 (Gelbart).

The radiation-sensitive composition can be applied to the substrate as a solution or dispersion in a coating liquid using any suitable equipment and procedure, such as spin coating, knife coating, gravure coating, die coating, slot coating, bar coating, wire rod coating, roller coating, or extrusion hopper coating. The composition can also be applied by spraying onto a suitable support (such as an on-press printing cylinder).

Illustrative of such manufacturing methods is mixing the components of the radiation-sensitive composition in a suitable organic solvent [such as methyl ethyl ketone (2-butanone), methanol, ethanol, 1-methoxy-2-propanol, *iso*-propyl alcohol, acetone, γ-butyrolactone, *n*-propanol, tetrahydrofuran, and others readily known in the art, as well as mixtures thereof], applying the resulting solution or dispersion to the desired substrate, and removing the solvent(s) by evaporation under suitable drying conditions. After proper drying, the coating weight of the imageable layer is generally from about 0.1 to about 5 g/m², preferably from about 0.5 to about 3.5 g/m², and more preferably from about 0.5 to about 1.5 g/m².

Layers can also be present between the substrate and the imageable layer to enhance developability or to act as a thermal insulating layer. The underlying layer should be soluble or at least dispersible in the developer and preferably have a relatively low thermal conductivity coefficient.

The imageable elements have any useful form including but not limited to, printing plate precursors, printing cylinders, printing sleeves and printing tapes (including flexible printing webs). Preferably, the imageable members are printing plate precursors that can be of any useful size and shape (for example, square or rectangular) having the requisite imageable layer disposed on a suitable substrate. Printing cylinders and sleeves are known as rotary printing members having the substrate and imageable layer in a cylindrical form. Hollow or solid metal cores can be used as substrates for printing sleeves.

### Imaging Conditions

During use, the imageable element is exposed to near-infrared, or infrared radiation (wavelength from 700 to 1200 nm), depending upon the sensitizer present in the radiation-sensitive composition. Preferably, imaging is carried out using an infrared laser. The laser used to expose the imageable element is preferably a diode laser, because of the reliability and low maintenance of diode laser systems, but other lasers such as gas or solid state lasers may also be used. Suitable exposure power, intensity and time for laser imaging would be readily apparent to one skilled in the art. Presently, high performance lasers or laser diodes used in commercially available imagesetters emit infrared radiation at a wavelength of from about 800 to about 850 nm or from about 1060 to about 1120 nm.

The imaging apparatus can function solely as a platesetter or it can be incorporated directly into a lithographic printing press. In the latter case, printing may commence immediately after imaging and development, thereby reducing press set-up time considerably. The imaging apparatus can be configured as a flatbed recorder or as a drum recorder, with the imageable member mounted to the interior or exterior cylindrical surface of the drum. An example of an useful imaging apparatus is available as models of Creo Trendsetter^{®} imagesetters available from Eastman Kodak Company (Burnaby, British Columbia, Canada) that contain laser diodes that emit near infrared radiation at a wavelength of about 830 nm. Other suitable imaging sources include the Crescent 42T Platesetter that operates at a wavelength of 1064 nm (available from Gerber Scientific, Chicago, IL) and the Screen PlateRite 4300 series or 8600 series platesetter (available from Screen, Chicago, IL). Additional useful sources of radiation include direct imaging presses that can be used to image an element while it is attached to the printing plate cylinder. An example of a suitable direct imaging printing press includes the Heidelberg SM74-DI press (available from Heidelberg, Dayton, OH).

Imaging can be carried out generally at an imaging energy of up to and including 500 mJ/cm², preferably at from about 50 to about 300 mJ/cm². Due to the high sensitivity of the radiation-sensitive composition of the present invention an imaging energy of 100 mJ/cm² or below is usually sufficient.

### Development and Printing

Without the need for a pre-heat step after imaging, the imaged elements can be developed "off-press" using conventional processing and a conventional aqueous or organic developer. Alternatively, the imaged elements can be developed "on-press" as described in more detail below.

For off-press development, the developer composition commonly includes surfactants, chelating agents (such as salts of ethylenediaminetetraacetic acid), alkaline components (such as inorganic metasilicates, organic metasilicates, hydroxides, and bicarbonates), and optionally organic solvents (such as benzyl alcohol). The pH of the alkaline developer is preferably from about 4 to about 14. The imaged elements are generally developed using conventional processing conditions. Both aqueous developers and solvent-based developers can be used with the latter type of alkaline developers being preferred.

Solvent-based developers are generally single-phase solutions of one or more organic solvents that are miscible with water. Useful organic solvents include the reaction products of phenol with ethylene oxide and propylene oxide [such as ethylene glycol phenyl ether (phenoxyethanol)], benzyl alcohol, esters of ethylene glycol and of propylene glycol with acids having 6 or less carbon atoms, and ethers of ethylene glycol, diethylene glycol, and of propylene glycol with alkyl groups having 6 or less carbon atoms, such as 2-ethylethanol and 2-butoxyethanol. The organic solvent(s) is generally present in an amount of from about 0.5 to about 15% based on total developer weight. These developers are preferred.

Aqueous alkaline developers generally have a pH of at least 7 and preferably of at least 11.

Representative solvent-based alkaline developers include ND-1 Developer, 955 Developer, Developer 980, Developer 1080, and 956 Developer (available from Kodak Polychrome Graphic a subsidiary of Eastman Kodak Company).

Developers having a pH of from about 4 to about 9 are useful for developing imaged elements in the absence of post-rinse and gumming steps after development (so called "single bath development"). Such developers contain in most cases hydrophilic polymers like gum arabic, polyvinyl alcohol, poly(acrylic acid), or other hydrophilic polymers to protect the developed plate against fingerprints and to prevent toning of the plate when used on a printing press. Generally, the developer is applied to the imaged element by rubbing or wiping the outer layer with an applicator containing the developer. Alternatively, the imaged element can be brushed with the developer or the developer may be applied by spraying to the outer layer with sufficient force to remove the unexposed regions. Still again, the imaged element can be immersed in the developer. In all instances, a developed lithographic printing plate is obtained.

Following this off-press development, the imaged element can be rinsed with water and dried in a suitable fashion. The dried element can also be treated with a conventional gumming solution (preferably gum arabic). In addition, a postbake operation can be carried out, with or without an overall exposure to UV or visible radiation. Alternatively, a post-UV floodwise exposure (without heat) can be used to enhance the performance of the imaged element.

Printing can be carried out by applying a lithographic ink and fountain solution to the printing surface of the imaged and developed element. The fountain solution is taken up by the non-image regions, that is, the surface of the hydrophilic substrate revealed by the development step, and the ink is taken up by the image (non-removed) regions of the imaged layer. The ink is then transferred to a suitable receiving material (such as cloth, paper, metal, glass, or plastic) to provide a desired impression of the image thereon. If desired, an intermediate "blanket" roller can be used to transfer the ink from the imaged member to the receiving material. The imaged members can be cleaned between impressions, if desired, using conventional cleaning means.

Depending on the specific components of the coating some imageable elements of this invention can also be developed "on-press". This type of development avoids the use of the developing solutions described above. The imaged element is directly mounted on press wherein the unexposed regions in the imageable layer are removed by a suitable fountain solution, lithographic ink, or both, during the initial impressions in printing. Typical ingredients of aqueous fountain solutions include pH buffers, desensitizing agents, surfactants and wetting agents, humectants, low boiling solvents, biocides, antifoaming agents, and sequestering agents. A representative example of a fountain solution is Varn Litho Etch 142W + Varn PAR (alcohol sub) (available from Varn International, Addison, IL).

The following examples are provided to illustrate the practice of the invention but are by no means intended to limit the invention in any manner.

### Examples

The following abbreviations are used:
- binder 1: copolymer of benzyl methacrylate/allyl methacrylate/methacrylic acid (molar ratio 20/60/40)
- binder 2: copolymer of methyl methacrylate/methacrylic acid/methacrylic acid esterfied with hydroxyethyl methacrylate (molar ratio 30/20/50)
- CIB: bis(4-cumyl) iodonium tetraphenyl borate
- CIChl: bis(4-cumyl) iodonium chloride
- IR-dye 1: 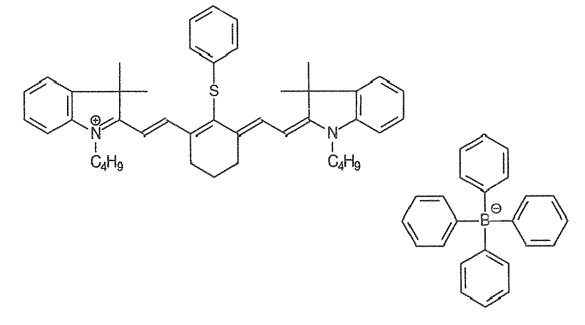
- IR-dye 2: 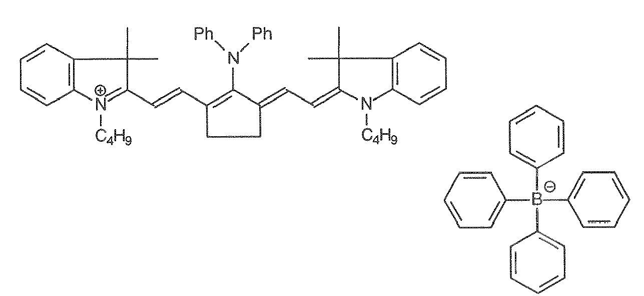
- IR-dye 3: 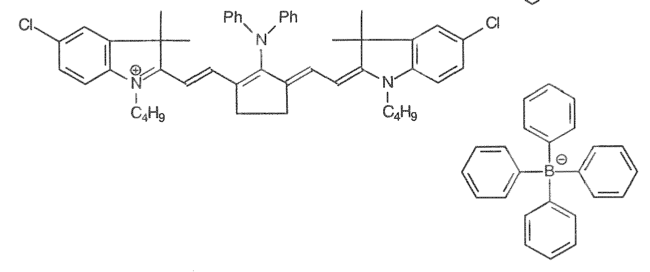
- IR-dye 4: 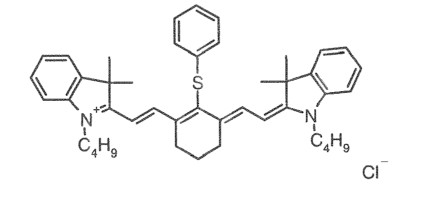
- IR-dye 5: 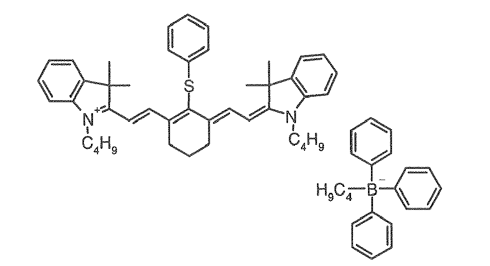
- IR-dye 6: 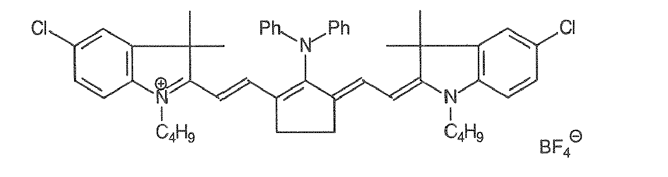
- Kayamer PM-2: ester of 1 mole phosphoric acid and 1.5 mole hydroxyethylmethacrylate, available from Nippon Kayaku/Japan
- monomer 1: mixture of 1 part of NK-Ester BPE-200 (ethoxylated bisphenole A having methacrylic end groups available from Shin Nakamura/Japan) and 3 parts of a 80% solution in methyl ethyl ketone of an oligomer obtained by reacting Desmodur® N100 (trifunctional isocyanate = biuret of hexamethylene diisocyanate, available from Bayer/Germany) with hydroxyethyl acrylate and pentaerythritol triacrylate (amount of double bonds in the oligomer: 0.5 double bonds per 100 g, when all isocyanate groups have reacted)
- monomer 2: mixture of 1 part of CN2302 (polyesteracrylate from Sartomer Corp.) and 3 parts of a solution of 30 weight% in methyl ethyl ketone of an oligomer obtained by reaction of 1 mol Desmodur® N100 (trifunctional isocyanate = biuret of hexamethylene diisocyanate, available from Bayer/Germany) + 2 mol glycerol dimethacrylate + 1 mol polyethylene glycol methacrylate
- monomer 3: mixture of 1 part of CN2302 and 3 parts of a solution of 30 weight% in ethyl ethyl ketone of an oligomer obtained by reaction of 2 mol hexamethylene diisocyanate + 2 mol 2-hydroxyethyl)methacrylate + 1 mol 2-(2-hydroxyethyl)-piperidine
- Na-Ph4B: sodium tetraphenyl borate
- NK Ester BPE-200: ethoxylated bisphenole A having methacrylic end groups, available from Shin Nakamura/Japan
- TPS-TPB: triphenylsulfonium tetraphenyl borate
- TPS-TSA: triphenylsulfonium p-totuene sulfonate
- Triazine A: 2-(4-methoxyphenyl)-4,6-bis-(trichloromethyl)-s-triazine
- ADAA: phenyliminodiacetic acid

### Examples 1 to 7 an Comparative Examples 1 to 8

An electrochemically grained and anodized aluminum foil with an oxide weight of 3 g/m² was subjected to an after treatment using an aqueous solution of polyvinyl phosphoric acid. The average roughness of the surface was 0.55 µm. Coating compositions corresponding to Table 1 were applied to the substrate after filtering with a wire bar coater. The coatings were dried for 4 minutes at 90°C. The coatings weights were 1.4 g/m².

**Table 1 Radiation-sensitive composition**

| | |
|---|---|
| 32 ml | propylene glycol monomethyl ether |
| 8 ml | methyl ethyl ketone |
| 0.09 g | IR dye corresponding to Table 2 |
| 2.28 g | binder polymer corresponding to Table 2 |
| 0.15 g | initiator corresponding to Table 2 |
| 4.3 g | radical polymerizable monomer/oligomer corresponding to Table 2 |
| 0.2 g | Kayamer PM-2 |
| 5.40 g | dispersion in propylene glycol monomethyl ether containing 9 wt% of copper phthalocyanine and 1 wt% of a polyvinylacetal binder containing 39.9 mol% units derived from vinyl alcohol, 1.2 mol% units derived from vinylacetate, 15.4 mol% acetal units derived from from acetaldehyde, 36.1 mol% acetal units derived from butyraldehyde and 7.4 mol% acetal units derived from 4-formylbenzoic acid |
| 0.15 g | 1H-1,2,4-triazole-5-thiol |

The obtained samples were overcoated with an aqueous solution of poly(vinyl alcohol) (Celvol 203 from Air Products, having a hydrolysis degree of 88%) with a wire bar coater and dried for 4 minutes at 90°C to get a printing precursor. The coating weight of the poly(vinyl alcohol) overcoat was 1 g/m².

The UGRA/FOGRA Postscript Strip version 2.0 EPS (available from UGRA), which contains different elements for evaluating the quality of the copies, was used for imaging the plates of the Examples and Comparative Examples with Trendsetter 3244 from Kodak (830nm). Photospeed of the plates exposed at 830 nm was evaluated by exposing the plate with different energies. The minimum energy required for obtaining a proper 1-pixel circular line was defined as the photo speed of the plate. The results are summarized in Table 2.

After washing off the water-soluble overcoat with water the plates were developed using the Kodak 980 developer.

For an estimation of the shelflife the plate were aged for 16 h at 60°C in an oven. The loss of tonal values of a 50 % tint in a 150 lpi screen compared to the fresh plate was taken as a criterion. We gave the following rating regarding the thermal stability:
++ <0.25% loss of tonal values; + < 1% loss of tonal values; - < 5 % loss of tonal values; -- < 10% loss of tonal values (See Table 2).

To measure the length of run plates were loaded in a sheet-fed offset printing machine using abrasive ink (Offset S 7184 available from Sun Chemical which contains 10% of calcium carbonate). The length of run of the plate is the number of copies when first sign of wear in solid areas of the plate become visible; the results are summarized in Table 2.

As is apparent from Table 2 imageable elements according to the present invention show a high photospeed as well as good shelflife and printing plates obtained therefrom can be used for a great number of copies. Responsible for these excellent properties is the combination of a sensitizer and an initiator as defined in the claims, in particular a sensitizer and an initiator having a tetraarylborate anion.

Comparison of Example 7 and Comparative Example 3 demonstrates that the replacement of the tetraarylborate anion in the initiator by another anion results in decrease of both sensitivity and print run length.

Comparative Example 1 shows that replacing the tetraarylborate of IR dye 1 (Example 1) by chloride results in lower photospeed and lower print run length.

From a comparison of Example 3 and Comparative Example 7 it is apparent that a tetrafluoro borate anion in the IR dye instead of a tetraarylborate anion results in a somewhat lower photospeed and worse shelflife although the initiator is an onium tetraarylborate; a similar result is obtained if an SIR dye with tetraarylborate anion is combined with an onium tetrafluoro borate initiator.

When comparing the results of Example 1 and Comparative Example 2 it is furthermore apparent that even replacing one of the four aryl substituents in the borate anion of the IR dye with an alkyl substituent results in both lower print run length and substantially lower shelflife. The same result is obtained when an IR dye with a borate according to the invention is used in combination with an onium compound with an alkyl-tritryl-borate anion or a benzyl-triaryl-borate anion.

Like in Comparative Example 8 no image is obtained up to 150 mJ/cm² if an ammonium tetraarylborate is used as initiator in combination with an IR absorber having a tetraarylborate anion.

**Table 2**

| | IR dye | initiator | binder polymer | radical polymerizable monomer/ oligomer | photo-speed [mJ/cm²] | shelflife | length of run (copies) |
|---|---|---|---|---|---|---|---|
| Example 1 | IR-dye 1 | CIB | binder 1 | monomer 1 | 70 | ++ | 150.000 |
| Example 2 | IR-dye 2 | CIB | binder 1 | monomer 1 | 70 | ++ | 150.000 |
| Example 3 | IR-dye 3 | CIB | binder 1 | monomer 1 | 70 | ++ | 140.000 |
| Example 4 | IR-dye 1 | CIB | binder 2 | monomer 1 | 70 | ++ | 150.000 |
| Example 5 | IR-dye 1 | CIB | binder 1 | monomer 2 | 70 | ++ | 170.000 |
| Example 6 | IR-dye 1 | CIB | binder 1 | monomer 3 | 70 | + | 150.000 |
| Example 7 | IR-dye 1 | TPS-TPB | binder 1 | monomer 1 | 85 | + | 140.000 |
| Comparative Example 1 | IR-dye 4 | CIB | binder 1 | monomer 1 | 90 | ++ | 130.000 |
| Comparative Example 2 | IR-dye 5 | CIB | binder 1 | monomer 1 | 70 | - | 140.000 |
| Comparative Example 3 | IR-dye 1 | TOPS-TEA | binder 1 | monomer 1 | 100 | + | 120.000 |
| Comparative Example 4 | IR-dye 1 | triazine A + ADAA¹⁾ | binder 1 | monomer 1 | 110 | ++ | 140.000 |
| Comparative Example 5 | IR-dye 5 | TPS-TSA | binder 1 | monomer 1 | 80 | -- | 120.000 |
| Comparative Example 6 | IR-dye 5 | ClHh1 | binder 1 | monomer 1 | 80 | - | 140.000 |
| Comparative Example 7 | IR-dye 6 | CIB | binder 1 | monomer 1 | 75 | - | 140.000 |
| Comparative Example 8 | IR-dye 3 | Na-Ph4B | binder 1 | monomer 1 | no image up to 150 mJ/cm² | - | n.d. |

| | | | | | | | |
|---|---|---|---|---|---|---|---|
| 1) the ratio of triazine A:ADAA is 65 wt-% to 35 wt-% n.d. = not determined | | | | | | | |

## Claims

1. A radiation-sensitive composition comprising:
(a) a sensitizer dye capable of absorbing radiation of the range of 700 to 1200 nm
(b) an initiator generating radicals in interacting with the exposed sensitizer
(c) a free radical polymerizable component, and
(d) optionally a polymeric binder,
wherein the sensitizer dye is a cationic dye having a tetraarylborate anion and the initiator is an onium compound selected from diaryliodonium tetraarylborates, triarylsulfonium tetraarylborates, diazonium tetraarylborates, phosphonium tetraarylborates, and N-heterocyclic onium tetraarylborates, wherein N is substituted with - OR wherein R is an optionally substituted hydrocarbyl group.

2. The composition of claim 1 wherein the onium compound is a diaryliodonium tetraarylborate or triarylsulfonium tetraarylborate.

3. The composition of claim 1 wherein the onium compound is an N-alkoxy pyridinium tetraarylborate.

4. The composition of any of claims 1 to 3 wherein the sensitizer dye is a cyanine dye.

5. The composition of any of claims 1 to 4 wherein the tetraarylborate anion of the sensitizer is a tetraphenylborate.

6. The composition of any of claims 1 to 4 wherein the tetraarylborate anion of the onium compound is a tetraphenylborate.

7. The composition of any one of claims 1 to 6 wherein both the anion of the sensitizer dye and the anion of the onium compound are tetraphenylborate.

8. The composition of claim 2 wherein said iodonium borate initiator composition includes one or more of diphenyliodonium tetraphenylborat, 4-octyloxyphenyl phenyliodonium tetraphenylborate, [4-[(2-hydroxytetradecyl)-oxy]phenyl]phenyliodonium tetraphenylborate, bis(4-*t*-butylphenyl)iodonium tetraphenylborate, 4-methylphenyl-4'-hexylphenyliodonium tetraphenylborate, 4-methylphenyl-4'-cyclohexylphenyliodonium tetraphenylborate, bis(*t*-butylphenyl)iodonium tetrakis(pentafluorophenyl)borate, 4-hexylphenyl-phenyliodonium tetraphenylborate, 4-cyclohexylphenyl-phenyliodonium tetraphenylborate, 2-methyl-4-*t*-butylphenyl-4'-methylphenyliodonium tetraphenylborate, 4-methylphenyl-4'-pentylphenyliodonium tetrakis[3,5-bis(trifluoromethyl)phenyl]borate, 4-methoxyphenyl-4'-cyclohexylphenyl-iodonium tetrakis(pentafluorophenyl)borate, 4-methylphenyl-4'-dodecylphenyliodonium tetrakis(4-fluorophenyl)borate, bis(dodecylphenyl)iodonium tetrakis(pentafluorophenyl)-borate, bis(4-*t*-butylphenyl)iodonium tetrakis(1-imidazolyl)borate, and bis(4-cumyl)iodonium tetraphenylborate.

9. A negative working imageable element comprising a substrate having thereon an imageable layer which comprises:
(a) a sensitizer dye capable of absorbing radiation of the range of 700 to 1200 nm
(b) an initiator generating radicals in interacting with the exposed sensitizer
(c) a free radical polymerizable component, and
(d) optionally a polymeric binder,
wherein the sensitizer dye is a cationic dye having a tetraarylborate anion and the initiator is an onium compound selected from diaryliodonium tetraarylborates, triarylsulfonium tetraarylborates, diazonium tetraarylborates, phosphonium tetraarylborates, and N-heterocyclic onium tetraarylborates, wherein N is substituted with -OR wherein R is an optionally substituted hydrocarbyl group.

10. A method of making an imaged element comprising:
A) imagewise exposing a negative-working imageable element as defined in claim 9 to radiation of a wavelength of the range of 700 to 1200 nm which is absorbed by the sensitizer;
B) developing said imagewise exposed element to remove only the non-exposed regions of the imageable layer.

11. An imaged element obtained by the method of claim 10.

12. A method of making an imageable element as defined in claim 8, comprising:
applying a radiation-sensitive composition as defined in any one of claims 1 to 8 to a substrate.
